# EUROPEAN PATENT SPECIFICATION

(11) **EP 4 187 289 B1**
(45) Date of publication and mention of the grant of the patent: **29.01.2025**
(21) Application number: 22207166.4
(22) Date of filing: 14.11.2022
(51) Int. Cl.: G02B 5/00, G02B 26/04

(54) **MICRO-ELECTRO-MECHANICAL OPTICAL SHUTTER WITH ROTATING SHIELDING STRUCTURES AND RELATED MANUFACTURING PROCESS**
MIKROELEKTROMECHANISCHER OPTISCHER VERSCHLUSS MIT ROTIERENDEN ABSCHIRMSTRUKTUREN UND ZUGEHÖRIGES HERSTELLUNGSVERFAHREN
OBTURATEUR OPTIQUE MICRO-ÉLECTROMÉCANIQUE À STRUCTURES DE BLINDAGE ROTATIVES ET PROCÉDÉ DE FABRICATION ASSOCIÉ

(30) Priority: 30.11.2021 IT 202100030269
(43) Date of publication of application: 31.05.2023
(73) Proprietor: STMicroelectronics S.r.l., 20864 Agrate Brianza (MB) (IT)
(72) Inventor: VERCESI, Federico, 20134 MILANO (IT); CERINI, Fabrizio, 20013 MAGENTA (MI) (IT); GUERINONI, Luca, 24022 ALZANO LOMBARDO (BG) (IT); BONI, Nicolò, MOUNTAIN VIEW, 94040 (US)
(74) Representative: Studio Torta S.p.A.

(56) References cited:
- SYMS R R A ET AL: "Sliding-blade MEMS iris and variable optical attenuator; Sliding-blade MEMS iris and variable optical attenuator", JOURNAL OF MICROMECHANICS AND MICROENGINEERING, INSTITUTE OF PHYSICS PUBLISHING, BRISTOL, GB, vol. 14, no. 12, 14 September 2004 (2004-09-14), pages 1700 - 1710, XP020069599, ISSN: 0960-1317, DOI: 10.1088/0960-1317/14/12/015
- SYMS RICHARD R. A.: "BSOI MOEMS", ALGORITHMS AND TECHNOLOGIES FOR MULTISPECTRAL, HYPERSPECTRAL, AND ULTRASPECTRAL IMAGERY XIX - PROCEEDINGS OF SPIE, vol. 5719, 22 January 2005 (2005-01-22), US, pages 83 - 94, XP055939862, ISSN: 0277-786X, ISBN: 978-1-5106-4548-6, DOI: 10.1117/12.600807

## Description

The present invention relates to a MEMS (Micro-ElectroMechanical System) optical shutter including translating shielding structures, as well as to the related manufacturing process.

As is known, mobile phones are today available equipped with improved camera modules, which guarantee levels of performance by now comparable with those of professional cameras. Such modules include sensors that are progressively larger and have progressively higher performance; however, it is known how only a few solutions make it possible to implement a typical characteristic of professional cameras: a variable optical aperture.

For instance, US 2019/0377174 describes a MEMS optical shutter including a pinhole, a blade, and an actuator designed to move the blade laterally with respect to the pinhole. Said solution, however, has available only a small number of degrees of freedom for adjustment of the optical aperture; in particular, adjustment of the optical aperture is limited to a portion of the perimeter of the optical aperture.

The paper "Sliding-blade MEMS iris and variable optical attenuator" of R.R.A. Syms et al., Journal of Micromechanics and Microengineering, Institute of Physics Publishing, Bristol (GB), vol.14, n.12, 14 September 2004, pp. 1700-1710 discloses a MEMS attenuator with a variable aperture of the iris type, which includes a substrate and a single bonded layer, which is etched so as to form a plurality of shutter blades, which are coated by a metallization. The shutter blades are driven by respective microactuators and shift in a synchronous way, so as to form a variable polygonal aperture.

The paper "BSOI MOEMS", of R.R.A. Syms et al., Algorithms and Technologies for Multispectral, Hyperspectral and Ultraspectral Imagery, XIX Proceedings of SPIE, vol.5719, 22 January 2005, pp.83-94, discloses devices of the type of the micro-opto-electromechanical systems (MOEMS) based on the technology of the silicon bonded on insulator (BSOI); these devices comprise multiple-blade irises.

The aim of the present invention is thus to provide a solution that will overcome at least in part the drawbacks of the prior art.

According to the present invention a MEMS optical shutter and a related manufacturing process are provided, as defined in the annexed claims.

For a better understanding of the present invention, embodiments thereof are now described, purely by way of non-limiting example, with reference to the attached drawings, wherein:
- Figure 1 is a schematic cross-sectional view of a MEMS shutter, taken along a line of section I-I represented in Figure 2;
- Figure 2 is a schematic top plan view with portions removed of the MEMS shutter illustrated in Figure 1;
- Figure 3 is a schematic perspective view of a portion of the MEMS shutter illustrated in Figure 1, in resting conditions;
- Figure 4 is a schematic top plan view of a portion of the MEMS shutter illustrated in Figure 3;
- Figures 5A and 5B are schematic cross-sectional views of the portion of MEMS shutter illustrated in Figure 4, taken, respectively, along the lines of section V-A - V-A and V-B - V-B;
- Figure 6 is a schematic perspective view of a further portion of the MEMS shutter illustrated in Figure 1, in resting conditions;
- Figure 7 is a schematic perspective view of the portion of the MEMS shutter illustrated in Figure 3, in conditions of actuation;
- Figure 8 is a schematic top plan view with portions removed of a variant of the present MEMS shutter;
- Figure 9 is a schematic top plan view with portions removed of a part of a further variant of the present MEMS shutter;
- Figures 10 and 13 are schematic top plan views with portions removed of variants of the present MEMS shutter;
- Figures 11A and 12A are schematic top plan views of portions of the MEMS shutter illustrated in Figure 10;
- Figures 11B and 12B are schematic cross-sectional views of portions of the MEMS shutter illustrated in Figure 10, taken, respectively, along the lines of section XIB - XIB and XIIB - XIIB represented, respectively, in Figures 11A and 12A;
- Figure 14A is a schematic top plan view of a portion of the MEMS shutter illustrated in Figure 13;
- Figure 14B is a schematic cross-sectional view of a portion of the MEMS shutter illustrated in Figure 13, taken along a line of section XIVB - XIVB represented in Figure 14A;
- Figures 15-29 are schematic cross-sectional views of a semiconductor wafer during successive steps of a manufacturing process; and
- Figure 30 is a schematic cross-sectional view of a variant of the MEMS shutter.

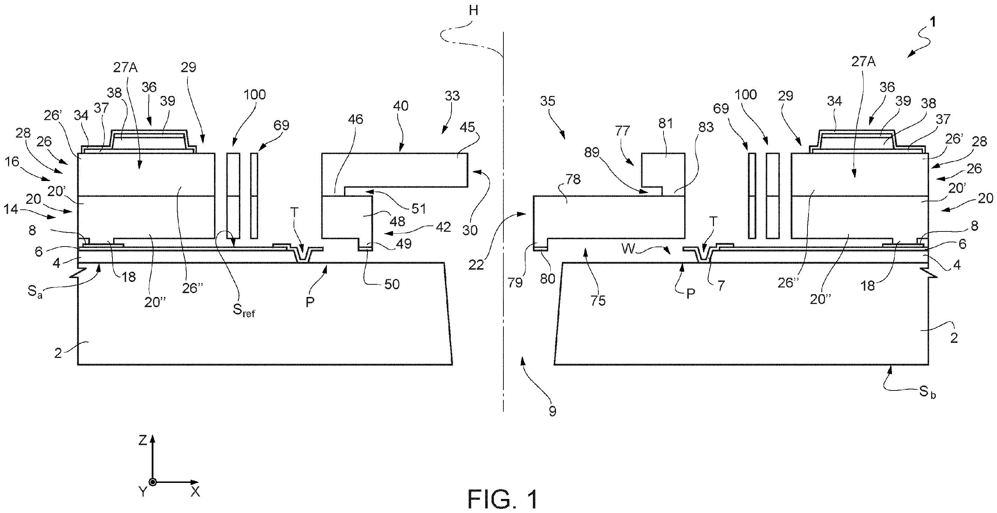

Figure 1 shows a MEMS shutter 1, which comprises a substrate 2 of semiconductor material (for example, silicon) and a first dielectric region **4,** which is arranged on the substrate 2 and is formed by thermal oxide.

In particular, the substrate 2 is delimited by a top surface Sₐ and a bottom surface S_{b}, which are parallel to a plane XY of an orthogonal reference system XYZ. The first dielectric region 4 extends on the top surface Sₐ and laterally delimits a window W, which leaves exposed a central portion of the top surface Sₐ; in other words, the first dielectric region 4 extends on a peripheral portion of the top surface Sₐ.

The MEMS shutter 1 further comprises a second dielectric region 6, which is made, for example, of aluminium oxide (alumina) and extends on a peripheral portion of the first dielectric region 4, leaving exposed an inner portion of the first dielectric region 4, which laterally delimits the aforementioned window W.

A main aperture 9 extends through the substrate 2 starting from the bottom surface S_{b} and giving out onto the central portion of the top surface Sₐ. In what follows it is assumed, for simplicity of description and without this implying any loss of generality, that the main aperture 9 has its axis of symmetry that coincides with an axis of symmetry H of the MEMS shutter 1, parallel to the axis Z. Furthermore, to a first approximation, the main aperture 9 has, for example, a frustoconical shape or a frustopyramidal shape with polygonal base, with the minor base that lies in the plane of the bottom surface S_{b}.

The window W communicates with the underlying main aperture 9 and is delimited at the bottom by a wall P, which is formed by a part of the substrate 2 that laterally delimits the top part of the main aperture 9 and has a plane and hollow shape. The wall P lies in the plane of the top surface Sₐ.

The MEMS shutter 1 further comprises a conductive layer 7, which has a closed shape in top plan view (for example, polygonal or circular) so as to surround the main aperture 9.

In particular, the conductive layer 7 has an approximately U-shaped cross-section so as to delimit a trench T.

An outer portion of the conductive layer 7 coats laterally and at the top the aforementioned inner portion of the first dielectric region 4 and further coats at the top a portion of the second dielectric region 6 facing the axis of symmetry H. A bottom portion of the conductive layer 7 coats an outer portion of the wall P; an inner portion of the conductive layer 7 extends in cantilever fashion from the bottom portion so as to overlie, at a distance, part of an inner portion of the wall P.

The MEMS shutter 1 further comprises a plurality of anchorage regions (two of which are illustrated in Figure 1 and designated by 8), which are made of polysilicon and extend on the second dielectric region 6. In particular, the anchorage regions 8 are arranged at a lateral distance from the conductive layer 7 and are arranged on the outside of the latter.

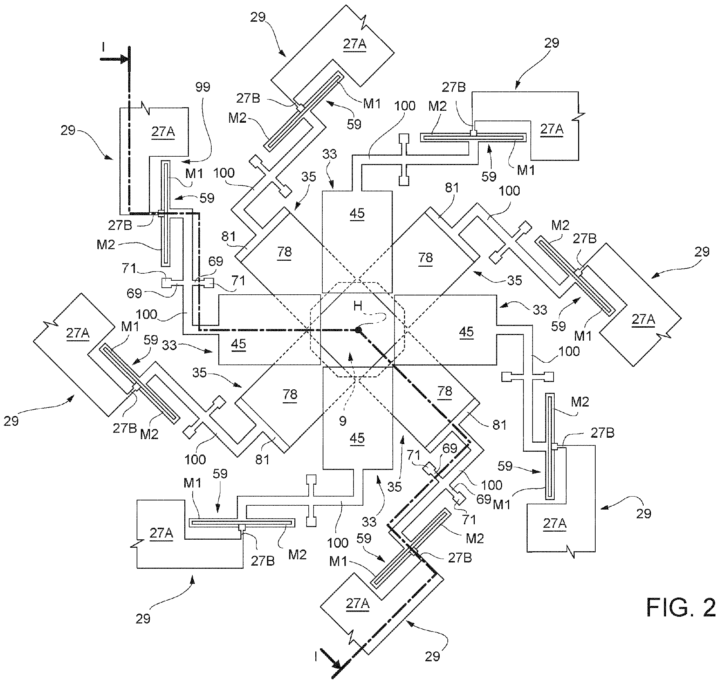

The MEMS shutter 1 further comprises a first semiconductor layer 14 and a second semiconductor layer 16, which are made of polycrystalline silicon and, as illustrated in Figure 2, form a plurality of first shielding structures 33 and a plurality of second shielding structures 35. In connection with Figure 2, the shape of the main aperture 9 shown therein is just qualitative and, for simplicity of representation, is not consistent with what is illustrated in Figure 1.

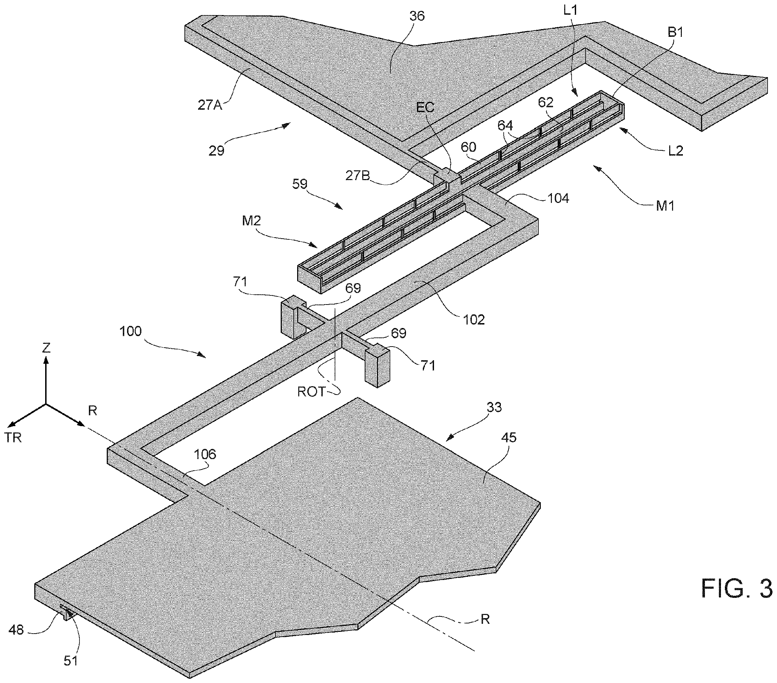

Each one of the first and second shielding structures 33, 35 is associated to a corresponding radial direction (one is illustrated in Figure 3, where it is designated by R), which is parallel to the plane XY and refers to the arrangement of the corresponding shielding structure when it is in resting conditions. As illustrated in Figure 2, in the present example it is assumed that both the first and the second shielding structures 33, 35 are four in number. Furthermore, it is anticipated that each one of the first and second shielding structures 33, 35 is associated to a corresponding transverse direction TR, which is perpendicular to the plane ZR; consequently, it is perpendicular to the corresponding radial direction R and also this refers to the arrangement of the corresponding shielding structure when it is in resting conditions.

In greater detail, the first semiconductor layer 14 forms: supporting regions 18, which overlie, in direct contact, corresponding anchorage regions 8; a bottom peripheral region 20; and a bottom inner structure 22, described in greater detail hereinafter.

The bottom peripheral region 20 forms a fixed bottom peripheral region 20', which overlies the supporting regions 18.

Furthermore, for each one of the first and second shielding structures 33, 35, the bottom peripheral region 20 forms a corresponding mobile bottom peripheral region 20", which extends in cantilever fashion from the fixed bottom peripheral region 20'. In particular, if we denote by S_{ref} the top surface of the second dielectric region 6, the mobile bottom peripheral region 20" overlies the surface S_{ref} at a distance.

The second semiconductor layer 16 forms a top peripheral region 26 and a top inner structure 30, described in greater detail hereinafter.

The top peripheral region 26 comprises a fixed top peripheral region 26', which overlies, in direct contact, the fixed bottom peripheral region 20', with which it forms a fixed peripheral structure 28.

Furthermore, for each one of the first and second shielding structures 33, 35, the top peripheral region 26 forms a corresponding mobile top peripheral region 26", which extends in direct contact on the corresponding mobile bottom peripheral region 20", with which it forms a corresponding cantilever structure 29, which extends in cantilever fashion from the aforementioned fixed peripheral structure 28.

As may be seen in Figure 3, each cantilever structure 29 comprises a main portion 27A and a secondary portion 27B, which are described hereinafter; the main portion 27A is visible also in Figure 1, albeit only approximately. In this connection, in general the figures are not in scale. As regards, instead, Figure 3, not shown therein is the separation between the first and second semiconductor layers 14, 16; on the other hand, this separation does not correspond to a physical interface, but rather represents the fact that the first and second semiconductor layers 14, 16, albeit made of a same material, are formed at different times, as explained hereinafter.

This having been said, and with reference to the cantilever structure 29 corresponding to the first shielding structure 33 illustrated in Figures 1 and 3 (but said description also applies to the other cantilever structures 29, also when coupled to the second shielding structures 35), albeit not shown a first end of the main portion 27A is fixed with respect to a corresponding portion of the fixed peripheral structure 28; the secondary portion 27B is arranged between the main portion 27A and the first shielding structure 33.

In greater detail, in resting conditions, the main portion 27A has a planar shape, elongated along an axis oriented at 90° with respect to the radial direction R, whereas the secondary portion 27B is elongated in a direction parallel to the radial direction R, with an approximately parallelepipedal shape. A first end of the secondary portion 27B is fixed with respect to the second end of the main portion 27A.

Without this implying any loss of generality, the main portion 27A has, in resting conditions and in top plan view, a shape tapered towards the secondary portion 27B so as to define a recess 99 (one of which is shown in Figure 2) having, for example, a square shape. The shape of the secondary portion 27A may, however, vary with respect to what is illustrated.

Once again with reference to Figure 1, the MEMS shutter 1 comprises, for each one of the first and second shielding structures 33, 35, a corresponding actuator 36 of a piezoelectric type, which extends on the main portion 27A of the corresponding cantilever structure 29.

Each actuator 36 comprises: a first electrode 37, arranged on the main portion 27A of the corresponding cantilever structure 29 and made, for example, of a material chosen from among: Mo, Pt, Ti, Al, TiW; a piezoelectric region 38, arranged on the first electrode 37 and made, for example, of a material chosen from among: PZT, AlN, scandium-doped AlN; a second electrode 39, arranged on the piezoelectric region 38 and made, for example, of a material chosen from among: Mo, Pt, Ti, Al, TiW; and a protective region 34, which is made, for example, of a material chosen from among silicon oxide, silicon nitride, and aluminium nitride and extends over the second electrode 39, as well as surrounding laterally the first and second electrodes 37, 39 and the piezoelectric region 38 until it comes into contact with the main portion 27A of the corresponding cantilever structure 29. In a per se known manner and thus not described in detail or illustrated, between the first and second electrodes 37, 39 a voltage may be applied, for example by appropriate electrical contacts (not illustrated), which enables operation of the actuator 36.

Once again with reference to the first and second shielding structures 33, 35, they are formed by the bottom inner structure 22 and the top inner structure 30.

In greater detail, the first shielding structures 33 are the same as one another and in resting conditions are spaced at equal angular distances apart with respect to the axis of symmetry H; in particular, pairs of adjacent first shielding structures 33 are spaced apart at an angular distance of 90°. The second shielding structures 35 are the same as one another and are spaced at equal angular distances apart with respect to the axis of symmetry H; in particular, pairs of adjacent second shielding structures 35 are spaced apart at an angular distance of 90°. Furthermore, the first and second shielding structures 33, 35 are arranged so as to alternate with one another at angular distances apart. Each first shielding structure 33 is thus angularly arranged between a pair of adjacent second shielding structures 35, which are at a distance of 45° from the first shielding structure 33; likewise, each second shielding structure 35 is angularly arranged between a pair of adjacent first shielding structures 33, which are at a distance of 45° from the second shielding structure 35.

In what follows, the first shielding structures 33 are described with reference to Figures 1 and 3, visible in which, as explained previously, is just one first shielding structure 33.

In detail, the first shielding structure 33 comprises a respective top shielding region 40, formed by the inner mobile portion 30 of the second semiconductor layer 16, and an underlying bottom secondary region 42, formed by the inner mobile portion 22 of the first semiconductor layer 14.

The top shielding region 40 has a rectangular shape, in top plan view, and an L-shaped cross-section. In particular, the top shielding region 40 comprises a main portion 45, which has the shape of a parallelepiped with axis parallel to the radial direction R and with ends facing, respectively, the axis of symmetry H and the top peripheral region 26, and a secondary portion 46, which has a parallelepipedal shape and is arranged underneath the end of the main portion 45 facing the top peripheral region 26.

The bottom secondary region 42 comprises a respective main portion 48, which has the shape of a parallelepiped with axis parallel to the radial direction R and with ends facing, respectively, the bottom peripheral region 20 and the axis of symmetry H, and a respective secondary portion 49, which has a parallelepipedal shape and is arranged underneath the end of the main portion 48 facing the axis of symmetry H.

The secondary portion 46 of the top shielding region 40 overlies, in direct contact, the end facing the bottom peripheral region 20 of the main portion 48 of the bottom secondary region 42. Extending underneath the secondary portion 49 of the bottom secondary region 42 is a suspended conductive region 50, made of polysilicon.

To a first approximation, and without this implying any loss of generality, the main portions 45, 48 and the secondary portions 46, 49 of the top shielding region 40 and the bottom secondary region 42 have a same extension in a direction parallel to the transverse direction TR associated to the first shielding region 33.

In greater detail, the main portion 45 of the top shielding region 40 and the main portion 48 of the bottom secondary region 42 extend in cantilever fashion from the secondary portion 46 of the top shielding region 40, towards the axis of symmetry H, without intercepting it, and delimiting, at the top and at the bottom respectively, a corresponding recess 51, which is laterally delimited by the secondary portion 46. In addition, in the radial direction R, the main portion 45 of the top shielding region 40 has a greater extension than the main portion 48 of the bottom secondary region 42, and is consequently at a shorter distance from the axis of symmetry H.

In resting conditions, at least part of the main portion 45 of the top shielding region 40 is suspended over the main aperture 9, i.e., it projects towards the axis of symmetry H, with respect to the underlying bottom secondary region 42.

Without this implying any loss of generality, the secondary portion 46 of the top shielding region 40 and the bottom secondary region 42 are laterally staggered with respect to the main aperture 9, i.e., they overlie portions of the substrate 2 adjacent to the main aperture 9. Albeit not illustrated, variants are, however, possible in which at least part of the bottom secondary region 42 is suspended over the main aperture 9.

The bottom inner structure 22 of the first semiconductor layer 14 and the top inner structure 30 of the second semiconductor layer 16 further form a corresponding deformable coupling structure 59 for each one of the first and second shielding structures 33, 35, as well as a corresponding coupling body 100. The deformable coupling structures 59, as also the coupling bodies 100, are the same as one another; for example, described in what follows are the deformable coupling structure 59 and the coupling body 100 for the first shielding structure 33 illustrated in Figures 1 and 3.

In detail, the deformable coupling structure 59 comprises a first elastic structure M1 and a second elastic structure M2, which in Figure 2 are represented in a simplified way.

The first and second elastic structures M1, M2 are the same as, and symmetrical to, one another, with respect to a plane perpendicular to the plane XY and parallel to the radial direction R. Consequently, described in what follows is just the first elastic structure M1.

The first elastic structure M1 is an elastic transformation element of the same type as the one described in the patent application EP3872451, filed on February 25, 2021 in the name of the present applicant. Furthermore, without this implying any loss of generality, the first elastic structure M1 extends at least in part within the recess 99, in order to reduce the overall dimensions.

In detail, the first elastic structure M1 comprises a first elongated structure L1 and a second elongated structure L2, a connecting arm B1 and an outer coupling region EC, which are now described with reference to the resting conditions illustrated in Figure 3. The outer coupling region EC is shared between the first and second elastic structures M1, M2.

The outer coupling region EC has approximately a parallelepipedal shape, is formed by the bottom inner structure 22 of the first semiconductor layer 14 and the top inner structure 30 of the second semiconductor layer 16, and is fixed with respect to the second end of the secondary portion 27B of the cantilever structure 29.

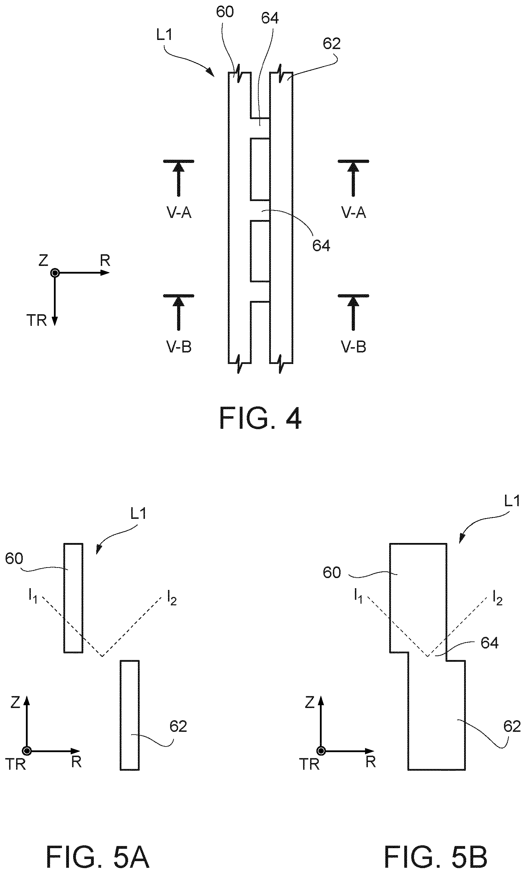

Without this implying any loss of generality, the first and second elongated structures L1 and L2 are the same as one another, are co-planar and are staggered in a direction parallel to the radial direction R. For this reason, just the first elongated structure L1 is described in what follows, with reference to Figures 4 and 5A-5B.

In detail, the first elongated structure L1 comprises a top elongated portion 60, formed by the top inner structure 30 of the second semiconductor layer 16, and a bottom elongated portion 62, formed by the bottom inner structure 22 of the first semiconductor layer 14.

The top elongated portion 60 and the bottom elongated portion 62 are staggered in a direction parallel to the radial direction R and have a parallelepipedal shape (for example, approximately the same shape) with axes parallel to the transverse direction TR and arranged at different heights, measured along the axis Z.

Without this implying any loss of generality, the top elongated portion 60 is located at a greater height than the bottom elongated portion 62; furthermore, the top elongated portion 60 and the bottom elongated portion 62 are vertically separate, i.e., they don't overlap one another in side view.

The first elongated structure L1 further comprises a plurality of transverse portions 64 (three of which are illustrated in Figure 3), which, without this implying any loss of generality, are the same as one another, have a parallelepipedal shape with axes parallel to the axis Z and are, for example, equally spaced apart in a direction parallel to the transverse direction TR. Furthermore, the transverse portions 64 are arranged between the top elongated portion 60 and the bottom elongated portion 62, which are arranged on opposite sides of each transverse portion 64. In particular, a top portion of each transverse portion 64 laterally contacts the top elongated portion 60, whereas a bottom part of the transverse portion 64 laterally contacts the bottom elongated portion 62. The top elongated portion 60, the bottom elongated portion 62 and the transverse portions 64 form a single piece of polysilicon.

The connecting arm B1 is formed by the bottom inner structure 22 of the first semiconductor layer 14 and the top inner structure 30 of the second semiconductor layer 16 and has an approximately planar shape (in particular, a parallelepipedal shape), parallel to the plane ZR. The first ends of the top elongated portion 60 and of the bottom elongated portion 62 are fixed with respect to the connecting arm B1. The second ends of the top elongated portion 60 and of the bottom elongated portion 62 are fixed with respect to the outer coupling region EC. Furthermore, the top elongated portion 60 and the bottom elongated portion 62 of the second elongated structure L2 have respective first ends, which are fixed with respect to the connecting arm B1, which is thus arranged between the first and second elongated structures L1, L2.

The second ends of the top elongated portion 60 and of the bottom elongated portion 62 of the second elongated structure L2 are fixed with respect to a first terminal portion (designated by 104) of the coupling body 100, which has approximately a parallelepipedal shape and is formed by the bottom inner structure 22 of the first semiconductor layer 14 and the top inner structure 30 of the second semiconductor layer 16.

In practice, the first elastic structure M1 has the shape of a folded spring, the behaviour of which is of the type described in the aforementioned patent application EP3872451 and is summarized hereinafter. Furthermore, the first elastic structure M1 is compliant along the axis Z and in a direction parallel to the radial direction R and is rigid in the transverse direction TR.

As illustrated in Figure 3, the coupling body 100 comprises, in addition to the aforementioned first terminal portion 104, an elongated portion 102 and a second terminal portion 106, which have parallelepipedal shapes and are formed by the inner mobile portion 22 of the first semiconductor layer 14 and by the inner mobile portion 30 of the second semiconductor layer 16. The elongated portion 102 is arranged between the first and second terminal portions 104, 106.

In detail, in resting conditions, the first and second terminal portions 104, 106 of the coupling body 100 extend in a direction parallel to the radial direction R, whereas the elongated portion 102 extends in a direction parallel to the transverse direction TR. Furthermore, the first and second terminal portions 104, 106 are laterally staggered in the transverse direction TR.

The first terminal portion 104 has a first end, which is fixed with respect to the second elongated structures L2 of the first and second elastic structures M1, M2, and a second end, which is fixed with respect to a first end of the elongated portion 102. The second terminal portion 106 has a first end, which is fixed with respect to the corresponding first shielding structure 33, and a second end, which is fixed with respect to the second end of the elongated portion 102. Furthermore, the first and second terminal portions 104, 106 extend on opposite sides with respect to the elongated portion 102, in such a way that the coupling body 100 is approximately Z-shaped in top plan view.

In greater detail, the first end of the second terminal portion 106 is fixed with respect to the top shielding region 40 and to the bottom secondary region 42 of the first shielding region 33.

Furthermore, as may be seen in Figures 2 and 3, for each first shielding structure 33, the MEMS shutter 1 comprises two planar springs 69, which are now described, by way of example, with reference to the first shielding structure 33 illustrated in Figure 3.

In detail, the planar springs 69 are formed by the inner mobile portion 22 of the first semiconductor layer 14 and by the inner mobile portion 30 of the second semiconductor layer 16 and have an elongated shape. In resting conditions, the planar springs 69 are shaped like parallelepipeds elongated in a direction parallel to the radial direction R, with first ends fixed with respect to the elongated portion 102 of the coupling body 100 (at a distance from the first and second terminal portions 104, 106) and with second ends fixed with respect to corresponding pillar regions 71. For reasons that will be clarified hereinafter, the planar springs 69 are rigid along the axis Z and compliant in a direction parallel to the corresponding radial direction R, and more in general in a direction parallel to the plane XY. In particular, the planar springs 69 function as flexural beams and, together with the first pillar regions 71, form a hinge for the coupling body 100.

In greater detail, the pillar regions 71 and the planar springs 69 are arranged on opposite sides of the elongated portion 102 of the coupling body 100. Furthermore, the pillar regions 71 are formed both by the first and second semiconductor layers 14, 16 (in particular, by portions of the fixed bottom peripheral region 20' and by underlying supporting regions 18, as well as by portions of the fixed top peripheral region 26') and are anchored at the bottom to corresponding anchorage regions 8.

In practice, the first shielding structure 33 and the coupling body 100 are suspended and constrained to the pillar regions 71 by interposition of the planar springs 69.

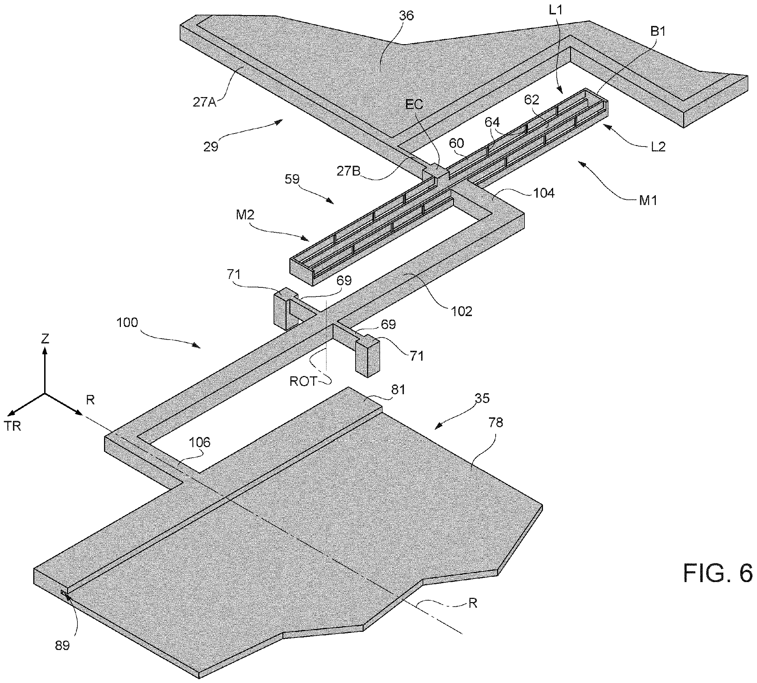

As regards the second shielding strucutres 35, they are now described with reference, by way of example, to the second shielding structure 35 illustrated in Figures 1 and 6.

In detail, the second shielding structure 35 comprises a respective bottom shielding region 75, formed by the bottom inner structure 22 of the first semiconductor layer 14, and an overlying top secondary region 77, formed by the top inner structure 30 of the second semiconductor layer 16.

The bottom shielding region 75 comprises a respective main portion 78, which has the shape of a parallelepiped with axis parallel to the radial direction R associated to the second shielding structure 35 and with ends facing, respectively, the axis of symmetry H and the bottom peripheral region 20. The bottom shielding region 75 further comprises a respective secondary portion 79, which has a parallelepipedal shape and is arranged underneath the end of the main portion 78 facing the axis of symmetry H. Extending underneath the secondary portion 79 is a corresponding suspended conductive region 80, made of polysilicon.

The top secondary region 77 comprises a respective main portion 81 and a respective secondary portion 83. The main portion 81 has the shape of a parallelepiped with axis parallel to the radial direction R associated to the second shielding structure 35 and with ends facing, respectively, the top peripheral region 26 and the axis of symmetry H. The secondary portion 83 has a parallelepipedal shape, is arranged underneath the end of the main portion 81 facing the top peripheral region 26, and further overlies, in direct contact, the end facing the bottom peripheral region 20 of the main portion 78 of the bottom shielding region 75.

To a first approximation, and without this implying any loss of generality, the main portions 78, 81 and the secondary portions 79, 83 of the bottom shielding region 75 and of the top secondary region 77 have a same extension in the transverse direction TR associated to the second shielding region 35.

Furthermore, the main portion 78 of the bottom shielding region 75 and the main portion 81 of the top secondary region 77 extend in cantilever fashion from the secondary portion 83 of the top secondary region 77, towards the axis of symmetry H, without intercepting it, and delimiting, at the top and at the bottom respectively, a corresponding recess 89, which is laterally delimited by the secondary portion 83 of the top secondary region 77.

In addition, in the radial direction R associated to the second shielding structure 35, the main portion 78 of the bottom shielding region 75 has a greater extension than the main portion 81 of the top secondary region 77, and is consequently at a shorter distance from the axis of symmetry H. Consequently, the main portion 81 of the top secondary region 77 leaves exposed a part facing the axis of symmetry H of the main portion 78 of the bottom shielding region 75.

In even greater detail, in resting conditions, the secondary portion 79 and at least part of the main portion 78 of the bottom shielding region 75 are suspended over the main aperture 9. Without this implying any loss of generality, the top secondary region 77 is laterally staggered with respect to the underlying main aperture 9, even though variants (not illustrated) are possible, in which at least part of the top secondary region 77 is vertically aligned with underlying portions of the main aperture 9.

As illustrated in Figure 6, coupling between the second shielding structure 35 and the corresponding cantilever structure 29 is obtained thanks to the interposition of the corresponding deformable coupling structure 59 and of the corresponding coupling body 100, in the same way as described with reference to the first shielding structure 33. In particular, the first end of the second terminal portion 106 of the coupling body 100 is fixed with respect to the bottom shielding region 75 and to the top secondary region 77.

Furthermore, for each second shielding structure 35, the MEMS shutter 1 comprises a respective pair of planar springs 69, which are mechanically coupled to the corresponding coupling body 100 and, respectively, to a corresponding pair of pillar regions 71, in the same way as described with reference to the first shielding regions 33.

All this having been said, in resting conditions the top shielding regions 40 of the first shielding structures 33 and the bottom shielding regions 75 of the second shielding structures 35 occlude partially the underlying main aperture 9. In particular, when the first and second shielding structures 33, 35 are in resting conditions, the minimum (partial) occlusion of the main aperture 9 is obtained; equivalently, in resting conditions the maximum optical aperture is obtained, understood as area of the main aperture 9 that may be traversed by a light beam that impinges with normal incidence upon the MEMS shutter 1. Furthermore, each actuator 36 may be operated so as to rotate the corresponding first/second shielding structure 33/35 so as to increase occlusion of the underlying main aperture 9, as described in detail hereinafter with reference to the first shielding structure 33 illustrated in Figure 3, even though the same considerations apply also to the second shielding structures 35.

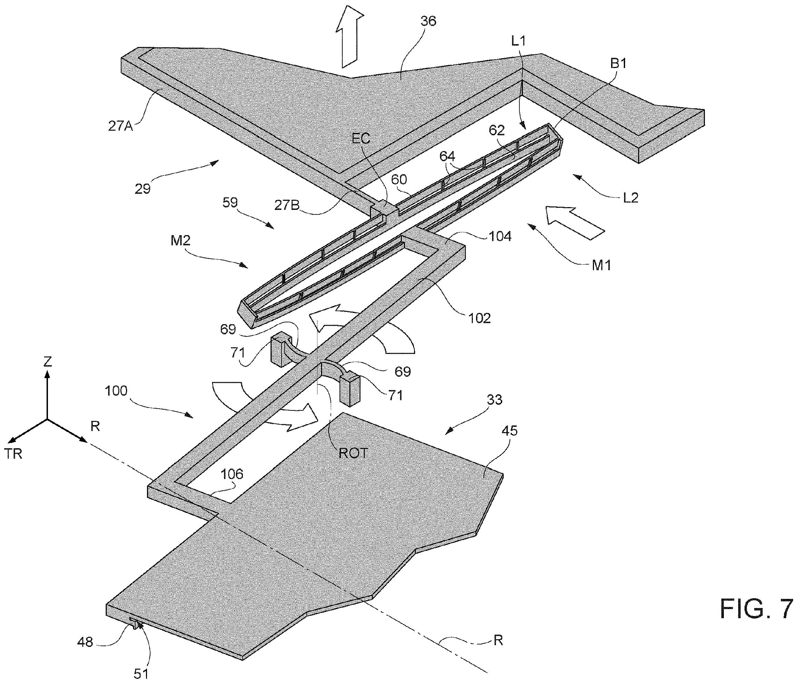

As illustrated in Figure 7, the actuator 36 may be operated so as to cause a translation along the axis Z of the corresponding cantilever structure 29, and consequently also of the corresponding outer coupling region EC, which drags upwards the portions of the first and second elastic structures M1, M2 fixed with respect thereto. Since the portions of the first and second elastic structures M1, M2 fixed with respect to the coupling body 100 cannot translate along the axis Z, on account of the constraint exerted by the corresponding planar springs 69, the deformable coupling structure 59 undergoes deformation as illustrated qualitatively in Figure 7.

In detail, the first and second elastic structures M1, M2 behave in the same way as described in the aforementioned patent application EP3872451. In particular, with reference, for example, to the first elastic structure M1, and further with reference, for example, to the first elongated structure L1, each section of the first elongated structure L1 taken in a plane parallel to the plane ZR has a pair of principal axes of inertia I₁, I₂ (illustrated in Figures 5A and 5B, which refer to Figure 4), each of which is transverse both with respect to the radial direction R and with respect to the axis Z. Consequently, a force applied to the first elongated structure L1 along the axis Z generates a so-called deviated flexure of the first elongated structure L1; in particular, said force causes a deformation along the axis Z, which leads to a consequent deformation in a direction parallel to the corresponding radial direction R of the first elongated structure L1.

In practice, whereas the portions of the first and second elastic structures M1, M2 fixed with respect to the outer coupling region EC translate to a first approximation along the axis Z, but do not undergo any movement in the plane XY, the portions of the first and second elastic structures M1, M2 fixed with respect to the coupling body 100 do not undergo translations along the axis Z, but translate in a direction parallel to the corresponding radial direction R, in a direction opposite to the axis of symmetry H, dragging the coupling body 100, and in particular the first terminal portion 104 of the latter.

On account of the action of dragging exerted by the deformable coupling structure 59 on the first terminal portion 104 and of the hinge formed by the planar springs 69 and by the pillar regions 71, the coupling body 100 rotates about an axis of rotation ROT (illustrated in Figures 3 and 7) parallel to the axis Z, without undergoing deformation and in a counterclockwise direction; to a first approximation, the axis of rotation ROT is arranged in such a way that the pillar regions 71 are arranged in a way symmetrical with respect thereto. Furthermore, the planar springs 69 undergo deformation, bending in the plane XY with curvatures opposite to one another so as to enable rotation of the coupling body 100 and thus also of the first shielding structure 33, which forms a rigid body with the coupling body 100 and rotates together with the latter; in this way, the area of overlapping between the first shielding structure 33 and the underlying main aperture 9 increases.

Occlusion of the main aperture 9 thus increases as the rotations of the first and second shielding structures 33, 35 increase. Furthermore, thanks to the fact that each first shielding structure 33 is angularly arranged between a pair of second shielding structures 35 and vice versa, and thanks to the fact that the top shielding regions 40 and the bottom shielding regions 75 are formed, respectively, by the second semiconductor layer 16 and by the first semiconductor layer 14 and are thus arranged on different levels, the movement of each shielding structure may take place in a way independent of the movement of the adjacent shielding structures, without there occurring any impact or limitation of the movement. In this connection, as illustrated in Figure 2, and without this implying any loss of generality, in resting conditions the end facing the axis of symmetry H of the main portion 45 of each top shielding region 40 overlies portions of the ends facing the axis of symmetry H of the main portions 78 of the two adjacent bottom shielding regions 75.

In practice, control of occlusion of the main aperture 9 is performed over the entire perimeter of the main aperture 9 and with a large number of degrees of freedom.

Albeit not illustrated, variants are further possible where the rotations of the shielding structures about the respective axes of rotation ROT occur in a clockwise direction; for this purpose, it is, for example, possible to arrange the coupling body 100, the planar springs 69, the pillar regions 71, the deformable coupling structure 59, and the cantilever structure 29 so that they are symmetrical with respect to the radial direction R, according to the configuration shown in Figure 3.

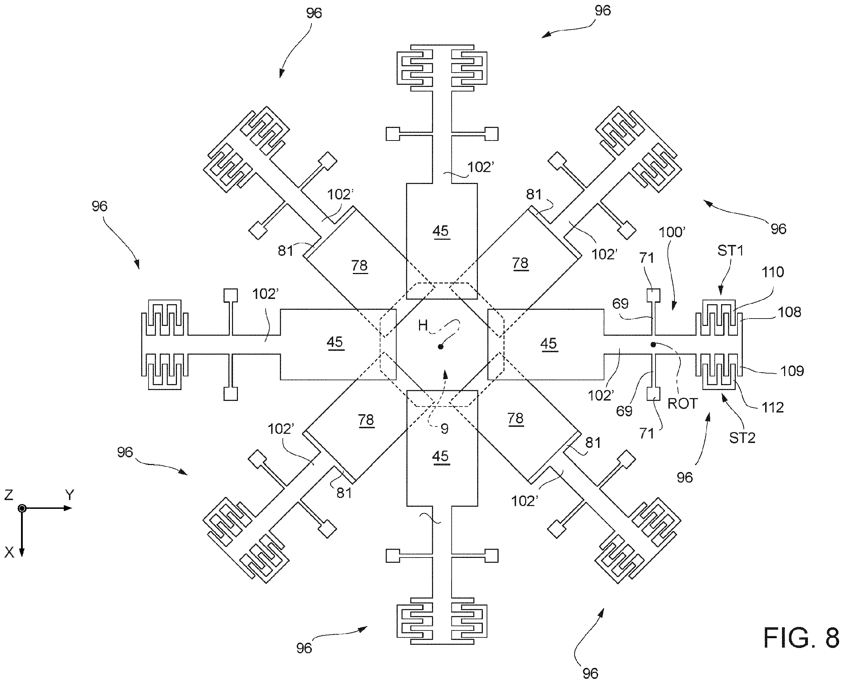

According to a variant illustrated in Figure 8, the first and second shielding structures 33, 35 are of the same type as described previously, have the same arrangement in resting conditions and have the same capacity of carrying out rotations, but the actuators (designated by 96) are of an electrostatic type. This variant is now described with reference, purely by way of example, to an actuator 96 coupled to a first shielding structure 33, but the description also applies to the actuators 96 coupled to the second shielding structures 35.

In detail, the actuator 96 is of an electrostatic type and comprises, for example, a first stator region ST1 and a second stator region ST2, which are formed by corresponding portions of the fixed peripheral structure 28 (i.e., by corresponding portions of the fixed bottom peripheral region 20' and of the fixed top peripheral region 26'), as well as by underlying supporting regions 18 and underlying anchorage regions 8. The first and second stator regions ST1, ST2 are thus fixed with respect to the underlying substrate 2.

Furthermore, the first shielding structure 33 is operatively coupled to the actuator 96 through the corresponding coupling body (designated by 100'), which comprises the respective elongated portion (here designated by 102').

The first and second stator regions ST1, ST2 are arranged on opposite sides of the first end of the elongated portion 102', from which they are electrically separate. Furthermore, the coupling body 100' comprises a first set and a second set of elongated elements 108, 109, which have a parallelepipedal shape and extend on opposite sides of the first end of the elongated portion 102', in a direction perpendicular with respect to the direction along which the elongated portion 102' extends; in this connection, in resting conditions, the direction along which the elongated portion 102' extends is parallel to the radial direction R (not illustrated in Figure 8) associated to the first shielding structure 33.

In greater detail, the first and second sets of elongated elements 108, 109 are formed by the bottom inner structure 22 of the first semiconductor layer 14 and the top inner structure 30 of the second semiconductor layer 16 and are laterally staggered in the direction along which the elongated portion 102' extends.

The first and second stator regions ST1, ST2 comprise respective pluralities of elongated elements (designated, respectively, by 110 and 112), which have a parallelepipedal shape and extend in a direction perpendicular with respect to the aforementioned radial direction R so as to be interdigitated with the first and second sets of elongated elements 108, 109, respectively.

The second end of the elongated portion 102' of the coupling body 100' is fixed with respect to the first shielding structure 33, and in particular to the shielding top structure 40 and to the bottom secondary region 42. Furthermore, the corresponding pair of planar springs 69 mechanically couples the elongated portion 102' to the corresponding pair of pillar regions 71, in the same way as described with reference to the previous embodiments.

In practice, the first end of the elongated portion 102' of the coupling body 100' forms a first capacitor and a second capacitor, respectively, with the first and second sets of elongated elements 108, 109, which may be controlled electronically in a per se known manner so as to generate an electrostatic force that causes a translation of the first end of the elongated portion 102' of the coupling body 100' alternatively towards the first or the second stator region ST1, ST2, i.e., in a direction perpendicular with respect to the radial direction R associated to the first shielding structure 33. Since the planar springs 69 and the pillar regions 71 form a corresponding hinge, this leads to a rotation of the coupling body 100' about the axis of rotation ROT, which is once again defined by the hinge formed by the planar springs 69 and by the pillar regions 71. The rotation is performed alternatively in a clockwise or counterclockwise direction, as a function of the direction of translation of the first end of the elongated portion 102' of the coupling body 100'.

Also in this embodiment, the coupling body 100' rotates without undergoing deformation, together with the first shielding structure 33. Albeit not illustrated, the planar springs 69 undergo deformation so as to enable rotation of the coupling body 100' and thus of the first shielding structure 33. In this way, the area of overlapping between the first shielding structure 33 and the underlying main aperture 9 varies and, in particular, increases with respect to the resting conditions.

In practice, also the embodiment illustrated in Figure 8 presents the same advantages as those described with reference to the embodiment illustrated in Figure 2. In connection with the latter embodiment, variants are possible such as to enable rotation of each shielding structure both in the clockwise direction and in the counterclockwise direction.

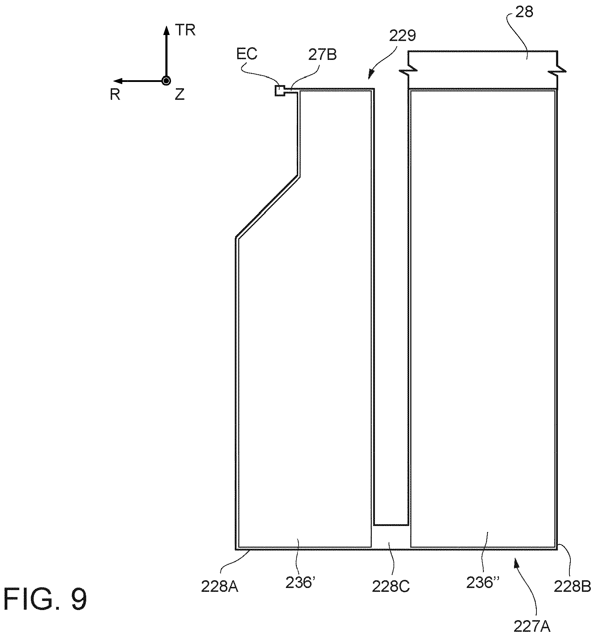

For instance, as illustrated in Figure 9, where for simplicity no shielding structure is illustrated, it is possible for each cantilever structure (here designated by 229) to comprise, in addition to the secondary portion 27B, which is fixed with respect to the corresponding outer coupling region EC, the main portion designated by 227A.

In detail, the main portion designated by 227A has a folded shape so as to define a sort of C shape in top plan view; in particular, the main portion 227A comprises a first elongated subportion 228A and a second elongated subportion 228B and a connecting subportion 228C. For instance, the first elongated subportion 228A has the same shape as the main portion 27A of the cantilever structure 29 illustrated in Figures 1-3. Furthermore, the second elongated subportion 228B has, for example, the shape of a parallelepiped elongated in a direction parallel to the corresponding transverse direction TR; the first and second elongated subportions 228A, 228B are staggered in the radial direction R and are connected by the connecting subportion 228C.

In greater detail, the end of the first elongated subportion 228A opposite to the deformable coupling structure 59 is fixed with respect to the connecting subportion 228C. A first end and a second end of the second elongated subportion 228B are fixed with respect to the fixed peripheral structure 28 and the connecting subportion 228C, respectively.

In addition, the first elongated subportion 228A is overlaid by a corresponding first actuator, here designated by 236', of the same type as the one described with reference to Figures 1-3, whereas the second elongated subportion 228B is overlaid by a corresponding second actuator, here designated by 236", of the same type as the one described with reference to Figures 1-3 and electrically uncoupled from the first actuator 236'. In this way, by supplying voltage alternatively to the first actuator 236' or the second actuator 236", translations of the secondary portion 27B along the axis Z in opposite directions are obtained, with consequent translations of the corresponding shielding structure in opposite directions.

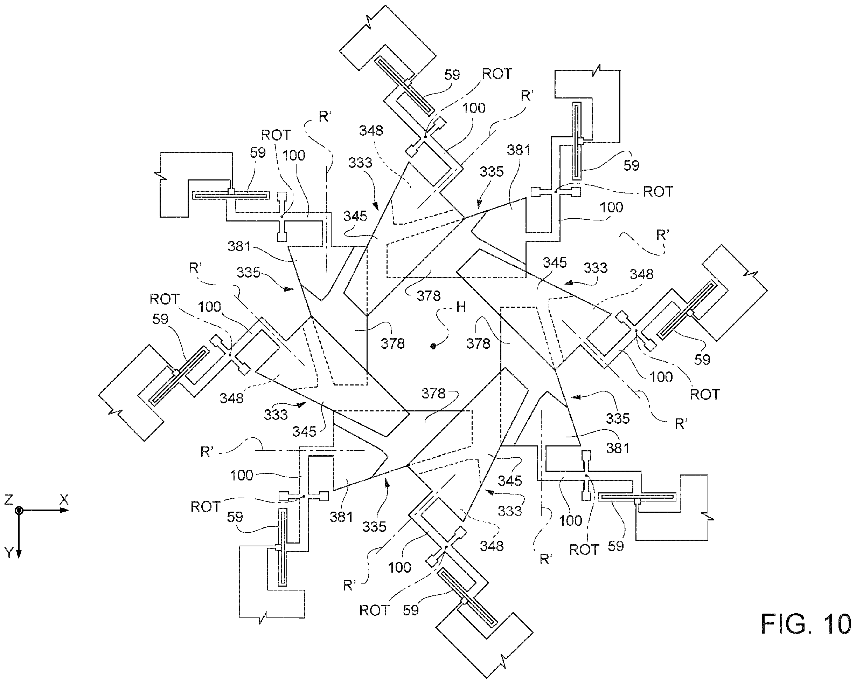

Irrespective of the type of embodiment, it is further possible for the first and second shielding structures, albeit maintaining an angularly alternating arrangement, to have a shape and/or arrangement different from what has been described, as illustrated, for example, in Figure 10, where the first and second shielding structures are, respectively, designated by 333 and 335, and where, purely by way of example, actuation of a piezoelectric type has been assumed, even though also in this case a variant with electrostatic actuation (not illustrated) is possible. For this reason, in what follows the description is limited to the differences with respect to what has been explained in connection with the embodiment illustrated in Figure 1. Elements already present in the embodiment illustrated in Figure 1 are designated by the same references, except where otherwise specified. Furthermore, in Figure 10 and in the subsequent figures, the deformable coupling structures 59 are illustrated in a simplified way. Once again, Figure 10 does not show that the first ends of the main portions 27A of the cantilever structures 29 are fixed with respect to corresponding portions of the fixed peripheral structure 28. Furthermore, in what follows, the terms "distal" and "proximal" are used to indicate parts of the shielding structures arranged, respectively, far from or near to the corresponding deformable coupling structures 59.

All this having been said, in resting conditions, each one of the first and second shielding structures 333, 335 extends in a direction parallel to a respective direction of extension (designated, respectively, by R'). In particular, in resting conditions, both the first and the second shielding structures 333, 335 have a same mutual arrangement with respect to the corresponding directions of extension R'.

The directions of extension R' are parallel to the plane XY, are co-planar and equidistant from the axis of symmetry H. In other words, in top plan view and in resting conditions, the directions of extension R' are to a first approximation tangential to a hypothetical circumference (not illustrated) centred on the axis of symmetry H. Furthermore, adjacent pairs of directions of extension R' form an angle equal to 45° so as to be angularly distributed over 360°.

Without this implying any loss of generality, for each shielding structure, the corresponding cantilever structure 29, the corresponding actuator 36, the corresponding deformable coupling structure 59 and the corresponding coupling body 100 have the same shapes as those described in connection with the embodiment illustrated in Figures 1-3, except that they refer to the corresponding direction of extension R', instead of to the aforementioned radial direction R, and except that, in top plan view, the deformable coupling structure 59 and the coupling body 100 are arranged on a side of the direction of extension R' such that the rotation of the corresponding shielding structure occurs in a clockwise direction and leads to an increase of the optical aperture.

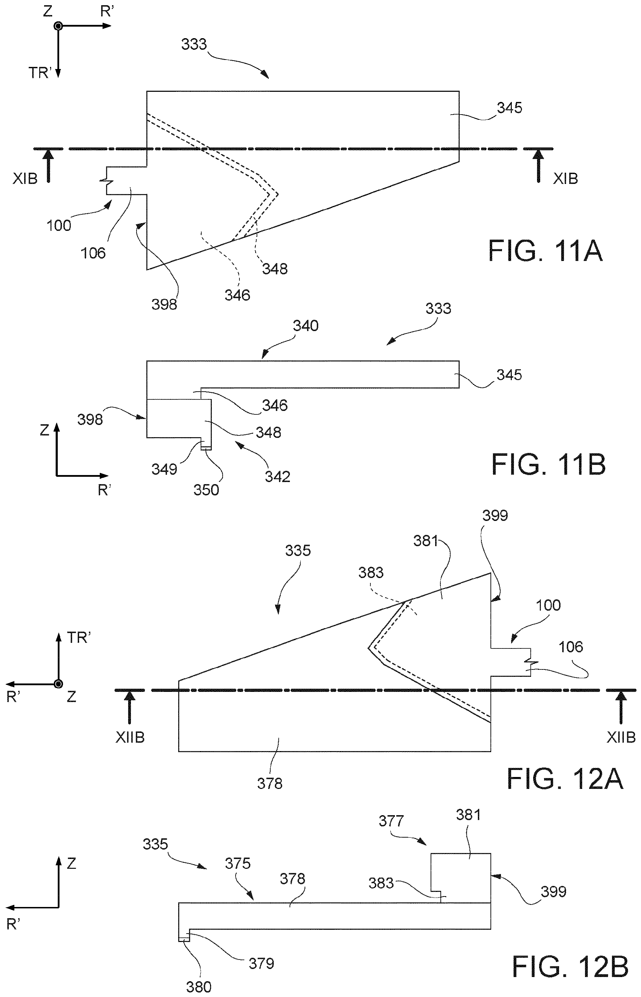

The shape of the first shielding structures 333, which are the same as one another, is now described with reference to the first shielding structure 333 illustrated in Figures 11A and 11B; further, referred to as "transverse direction" (which is denoted by TR') is a direction perpendicular to the plane ZR'.

In detail, the main portion (designated by 345) of the top shielding region (designated by 340) is tapered in a direction parallel to the direction of extension R'; i.e., it has an extension in the transverse direction TR' that decreases as the distance from the respective deformable coupling structure 59 increases.

In top plan view, the main portion (designated by 348) of the bottom secondary region (designated by 342) has approximately a wedge shape and, in addition to having, in a direction parallel to the direction of extension R', a maximum dimension smaller than the maximum dimension of the main portion 345 of the top shielding region 340, is also tapered in a direction parallel to the direction of extension R'. Furthermore, the maximum extension of the main portion 348 of the bottom secondary region 342 in a direction parallel to the transverse direction TR' is less than the maximum extension, in the same direction, of the main portion 345 of the top shielding region 340.

The secondary portion (designated by 346) of the top shielding region 340 has approximately the same shape, in top plan view, as the main portion 348 of the bottom secondary region 342, except for a recess. In other words, and without this implying any loss of generality, the secondary portion 346 overlies a proximal part of the main portion 348 of the bottom secondary region 342, leaving exposed a distal part of the main portion 348 of the bottom secondary region 342.

The secondary portion of the bottom secondary region 342 and the underlying suspended conductive region are designated, respectively, by 349 and 350.

In even greater detail, the main portion 345 of the top shielding region 340 extends in cantilever fashion with respect to the secondary portion 346 of the top shielding region 340 so as to project beyond the main portion 348 of the bottom secondary region 342, not only in a direction parallel to the direction of extension R' but also in a direction parallel to the transverse direction TR' for reasons that will be clarified hereinafter. In other words, both a distal part and a proximal part of the main portion 345 of the top shielding region 340, referred to in what follows as the projecting proximal part of the main portion 345, are suspended and project laterally with respect to the underlying bottom secondary region 342.

The main portion 340 and the secondary portion 346 of the top shielding region 340 and the main portion 348 of the bottom secondary region 342 form a coupling wall 398, which is perpendicular to the direction of extension R'. Without this implying any loss of generality, the second terminal portion 106 of the coupling body 100 is fixed with respect to a portion of the coupling wall 398.

As regards the second shielding structures 335, which are the same as one another, their shape is now described with reference to the second shielding structure 335 illustrated in Figures 12A and 12B.

In detail, the main portion (designated by 378) of the bottom shielding region (designated by 375) has approximately the same shape as the main portions 345 of the top shielding regions 340, with respect to which it is vertically staggered.

The main portion (designated by 381) and the secondary portion (designated by 383) of the top secondary region (designated by 377) have approximately the same wedge shapes as the main portion 348 of the bottom secondary region 342 and as the secondary portion 346 of the top shielding region 340, respectively. Consequently, the main portion 381 of the top secondary region 377 overlies entirely the secondary portion 383, but leaves exposed a distal part and a proximal part of the main portion 378 of the bottom shielding region 375 (referred to in what follows as the exposed proximal part), which project, respectively, in a direction parallel to the direction of extension R' and in a direction parallel to the transverse direction TR'.

The secondary portion of the bottom shielding region 375 and the underlying suspended conductive region are designated, respectively, by 379 and 380.

The main portion 381 and the secondary portion 383 of the top secondary region 377 and the main portion 378 of the bottom shielding region 375 form a coupling wall 399, which is perpendicular to the direction of extension R'. Without this implying any loss of generality, the second terminal portion 106 of the coupling body 100 is fixed with respect to a portion of the coupling wall 399.

Thanks to the geometrical shapes of the first and second shielding structures 333, 335, in resting conditions what has been described hereinafter occurs.

In detail, considering any first shielding structure 333, the distal part of the main portion 345 of the respective top shielding region 340 overlies, at a distance, the exposed proximal part of the main portion 378 of the bottom shielding region 375 of the second shielding structure 335 adjacent to the shielding structure 333 and arranged in a counterclockwise direction.

In addition, the projecting proximal part of the main portion 345 of the top shielding region 340 overlies, at a distance, the distal part of the main portion 378 of the bottom shielding region 375 of the second shielding structure 335 adjacent to the shielding structure 333 and arranged in a clockwise direction.

Furthermore, the first and second shielding structures 333, 335 may rotate about the respective axes of rotation, in a clockwise direction so as to reduce occlusion of the underlying main aperture 9 (not illustrated in Figure 12), i.e., so as to increase the optical aperture with respect to the resting conditions. The maximum degree of the rotation is a function of the shapes of the distal parts of the main portions 345 of the top shielding regions 340 and of the exposed proximal parts of the main portions 378 of the bottom shielding regions 375.

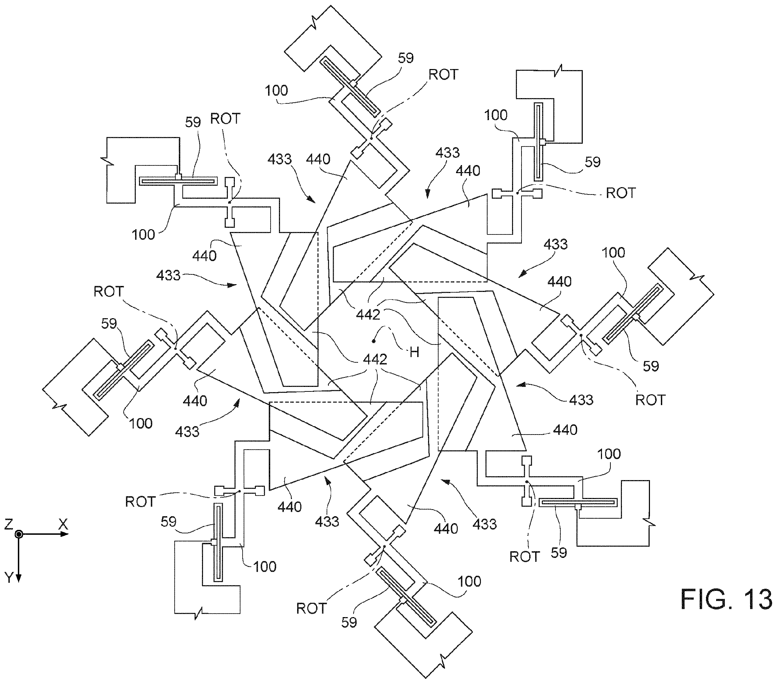

According to a further variant, the MEMS shutter 1 may be without the second shielding structures, as illustrated in Figure 13, where the first shielding structures are designated by 433. Also in Figure 13, the main aperture 9 is not represented.

This having been said, the MEMS shutter 1 differs from what is illustrated in Figure 10 in that it includes eight first shielding structures 433, which are the same as one another and are spaced at equal angular distances apart (in resting conditions).

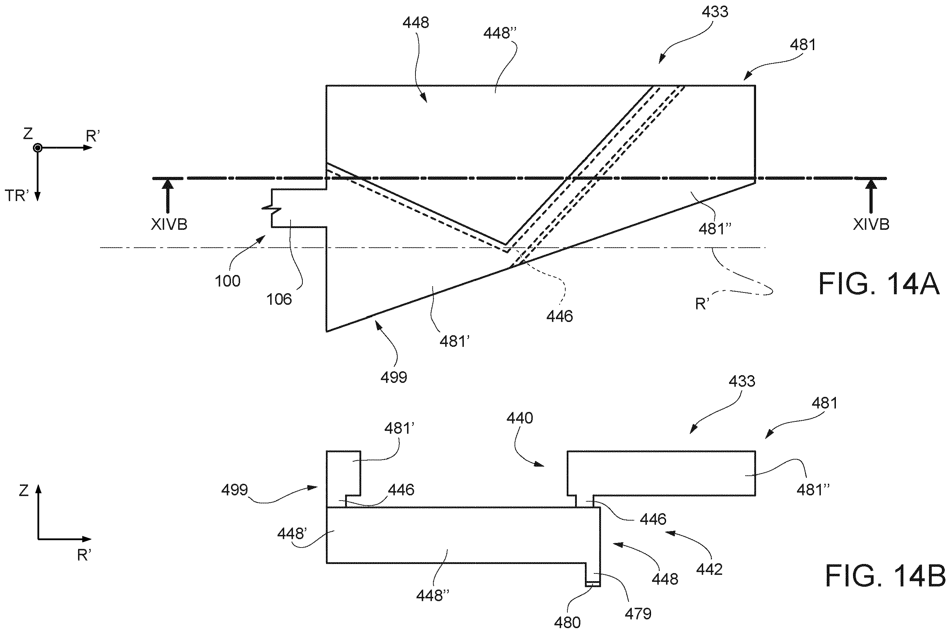

As illustrated in Figures 14A-14B, each first shielding structure 433 comprises a respective top shielding region 440, formed by the top inner structure 30 of the second semiconductor layer 16, and a respective bottom shielding region 442, formed by the bottom inner structure 22 of the first semiconductor layer 14.

The top shielding region 440 comprises a respective secondary portion 446 and a respective main portion 481; the bottom shielding region 442 comprises a respective main portion 448 and a respective secondary portion 479. The underlying suspended conductive region is designated by 480.

A proximal part 481' of the main portion 481 and the secondary portion 446 of the top shielding region 440 form, together with a first part 448' of the main portion 448 of the bottom shielding region 442, a main body 499; the second terminal portion 106 of the coupling body 100 is fixed with respect to the main body 499.

A distal part 481" of the main portion 481 of the top shielding region 440 extends in cantilever fashion from the main body 499, in a direction approximately parallel to the corresponding direction of extension R', projecting with respect to the underlying bottom shielding region 442.

A second part 448" of the main portion 448 of the bottom shielding region 442 is left exposed by the overlying top shielding region 440 and is laterally staggered with respect to the main body 499.

Thanks to the aforementioned shape of the first shielding structures 433, in resting conditions it happens that, as illustrated in Figure 13, the distal part 481" of the main portion 481 of the top shielding region 440 of any first shielding structure 433 overlies, at a distance, the second part 448" of the main portion 448 of the bottom shielding region 442 of the first shielding structure that is adjacent and arranged in a counterclockwise direction. Furthermore, the second part 448" of the main portion 448 of the bottom shielding region 442 of any first shielding structure 433 is overlaid, at a distance, by the distal part 481" of the main portion 481 of the top shielding region 440 of the first shielding structure that is adjacent and arranged in a clockwise direction.

The first shielding structures 433 may rotate about the respective axes of rotation ROT in the same way as described with reference to Figure 10, the maximum degree of the rotation being a function of the shapes of the distal part 481' of the main portion 481 of the top shielding region 440 and of the second part 448" of the main portion 448 of the bottom shielding region 442.

Albeit not illustrated, variants are further possible where the MEMS shutter 1 is of the same type as that illustrated in Figure 10 or Figure 13, but in which piezoelectric actuation is of a bidirectional type, as illustrated in Figure 9, or else is of an electrostatic type, in which case the shielding structures are coupled to corresponding coupling bodies 100'.

The present MEMS shutter 1 may be manufactured using the process described hereinafter with reference, for example, to an embodiment of the type illustrated in Figure 1.

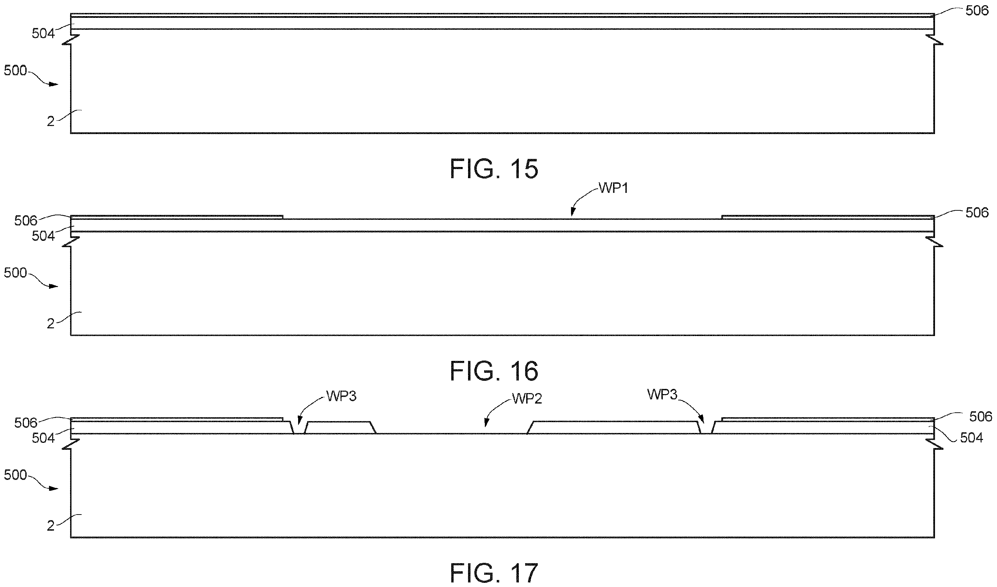

As shown in Figure 15, the present process initially envisages forming a first dielectric layer 504 and a second dielectric layer 506 on the substrate 2 of a semiconductor wafer 500; the first and second dielectric layers 504, 506 are made, respectively, of thermal oxide and aluminium oxide.

Next, as illustrated in Figure 16, a part of the second dielectric layer 506 is selectively removed so as to form a first preliminary opening WP1 through the second dielectric layer 506 in order to expose a part of the first dielectric layer 504.

Then, as illustrated in Figure 17, portions of the exposed part of the first dielectric layer 504 are selectively removed so as to form, through the first dielectric layer 504, a second preliminary opening WP2 and a third preliminary opening WP3, which is shaped like a trench and surrounds laterally, at a distance, the second preliminary opening WP2.

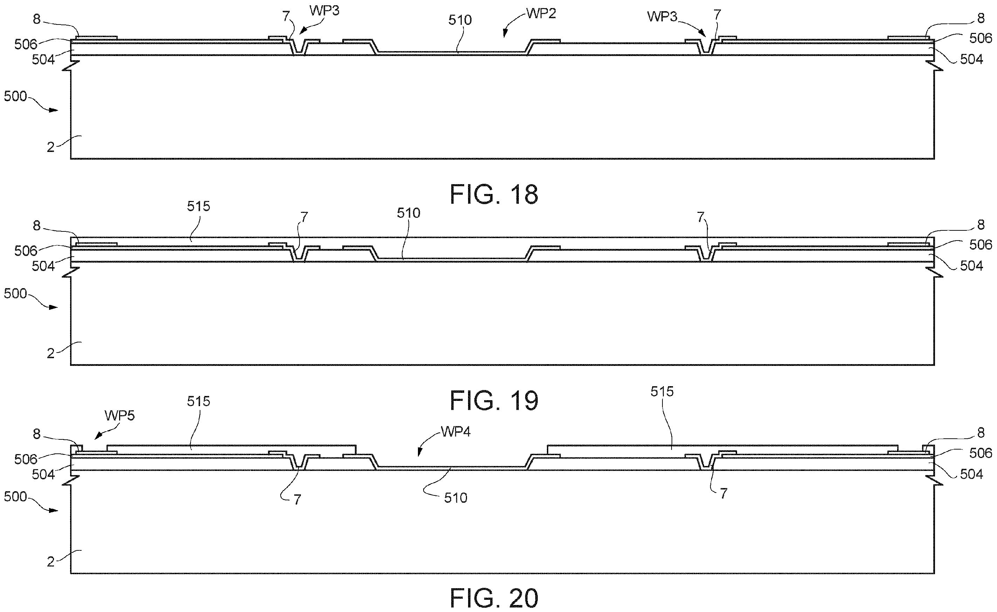

Next, as illustrated in Figure 18, polysilicon is deposited, followed by selective etching so that the residual polysilicon forms the conductive layer 7, within the third preliminary opening WP3, as well as the anchorage regions 8 and an intermediate conductive region 510, which extends in the second preliminary opening WP2, in contact with the substrate 2, as well as over portions of the first dielectric layer 504 that laterally delimit the second preliminary opening WP2. The conductive layer 7 and the intermediate conductive region 510 are separated from one another laterally; consequently, the aforementioned operations of deposition of polysilicon and of subsequent etching leave exposed parts of the first dielectric layer 504, which are laterally staggered with respect to the conductive layer 7 and to the intermediate conductive region 510. Furthermore, portions of the second semiconductor layer 506 arranged on the outside of the conductive layer 7 and laterally staggered with respect to the anchorage regions 8 remain exposed.

Then, as illustrated in Figure 19, a first sacrificial region 515 is formed and then planarized (step not represented in detail), on the conductive layer 7, on the anchorage regions 8, and on the intermediate conductive region 510, as well as on the exposed portions of the first and second dielectric layers 504, 506. In particular, the first sacrificial region 515 is made of TEOS oxide laid by chemical-vapour deposition.

Next, as illustrated in Figure 20, an etch is made for selective removal of portions of the first sacrificial region 515 arranged on the anchorage regions 8 and on the intermediate conductive region 510. In particular, a corresponding fourth preliminary opening WP4 is formed, which traverses the first sacrificial region 515 and gives out onto an inner portion of the intermediate conductive region 510, which is thus exposed. Without this implying any loss of generality, this inner portion of the intermediate conductive region 510 includes, in addition to the part of the intermediate conductive region 510 arranged in contact with the substrate 2, also parts of the intermediate conductive region 510 that extend on the first dielectric layer 504. Furthermore, fifth preliminary openings WP5 are formed, which traverse the first sacrificial region 515 and give out onto corresponding anchorage regions 8.

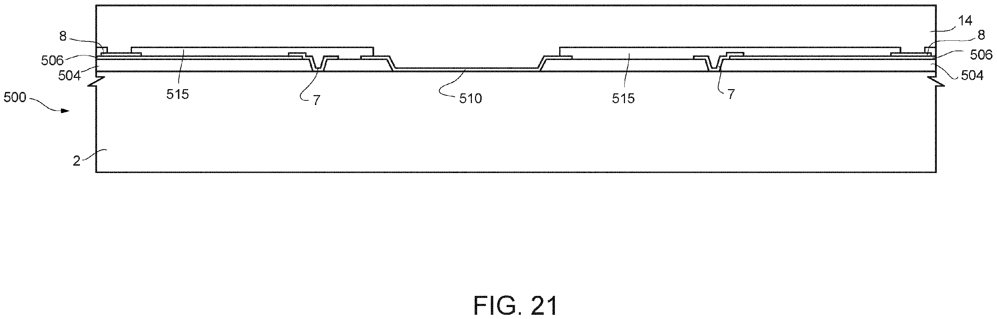

Then, as illustrated in Figure 21, a first epitaxial growth of silicon is carried out so as to form, and then planarize (step not represented in detail), the first semiconductor layer 14, which is made, as has been said, of polycrystalline silicon, and extends on the first sacrificial region 515, as well as within the fourth preliminary opening WP4, in direct contact with the intermediate conductive region 510, and within the fifth preliminary openings WP5, in direct contact with the anchorage regions 8. In particular, the portions of the first semiconductor layer 14 that extend within the fifth preliminary openings WP5 form the aforementioned supporting regions 18, i.e., the anchorages of the first semiconductor layer 14.

Albeit not illustrated, in an optional way it is possible that, using a mask, portions of the first semiconductor layer 14 that are laterally staggered with respect to the anchorage regions 8 and to the intermediate conductive region 510 are subsequently removed in a selective way so as to define corresponding portions of the MEMS shutter 1, such as the bottom elongated portions 62 of the first and second elastic structures M1, M2. In this case, optional openings are formed through the first semiconductor layer 14, delimited at the bottom by the first sacrificial region 515.

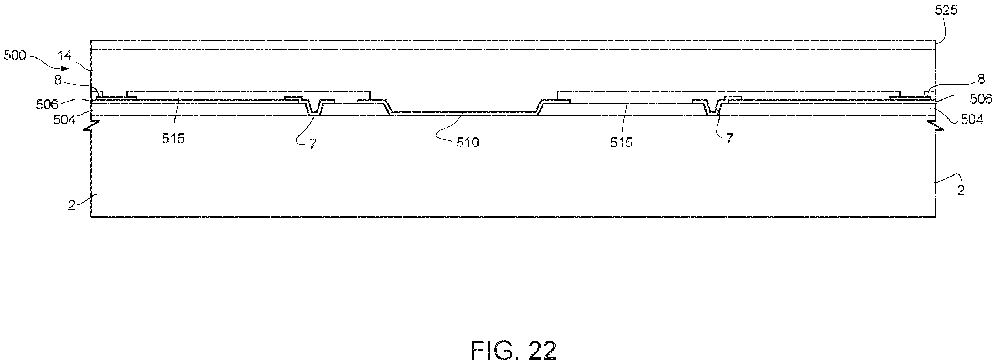

Next, as illustrated in Figure 22, a second sacrificial region 525 is formed by chemical-vapour deposition, the second sacrificial region 525 consisting of TEOS oxide and extending on the first semiconductor layer 14, as well as possibly within the aforementioned optional openings.

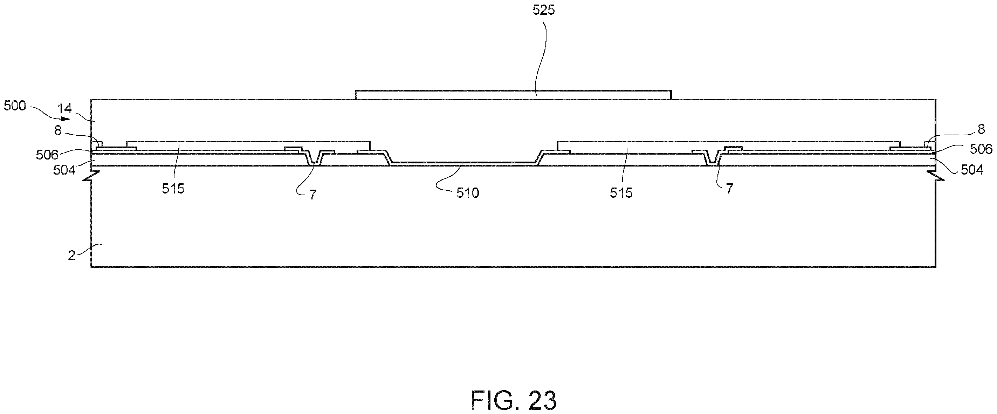

Then, as illustrated in Figure 23, a selective etch is made so as to remove portions of the second sacrificial region 525 that are arranged on the first semiconductor layer 14 and are laterally staggered with respect to the intermediate conductive region 510 in order to expose corresponding portions of the first semiconductor layer 14.

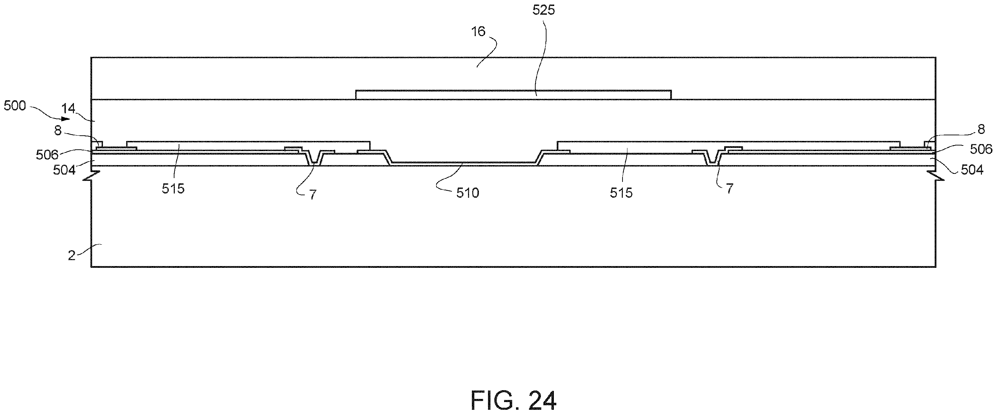

Next, as illustrated in Figure 24, a second epitaxial growth of silicon is carried out so as to form, and then planarize (step not represented in detail), the second semiconductor layer 16, which is made, as has been said, of polycrystalline silicon and extends on the second sacrificial region 525, as well as on the exposed portions of the first semiconductor layer 14. The portions of the second semiconductor layer 16 that contact the first semiconductor layer 14 are to form the top peripheral region 26 and part of the deformable coupling structures 59, in addition to corresponding portions of the coupling bodies 100, of the planar springs 69 and of the pillar regions 71, as well as the secondary portions 46 of the top shielding regions 40 of the first shielding structures 33 and the secondary portions 83 of the top secondary regions 77 of the second shielding structures 35.

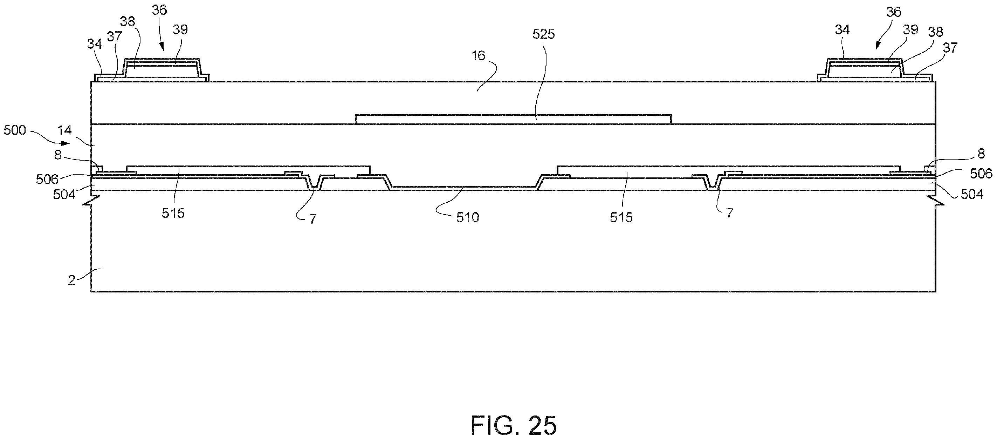

Then, in a per se known manner the actuators 36 are formed, as illustrated in Figure 25.

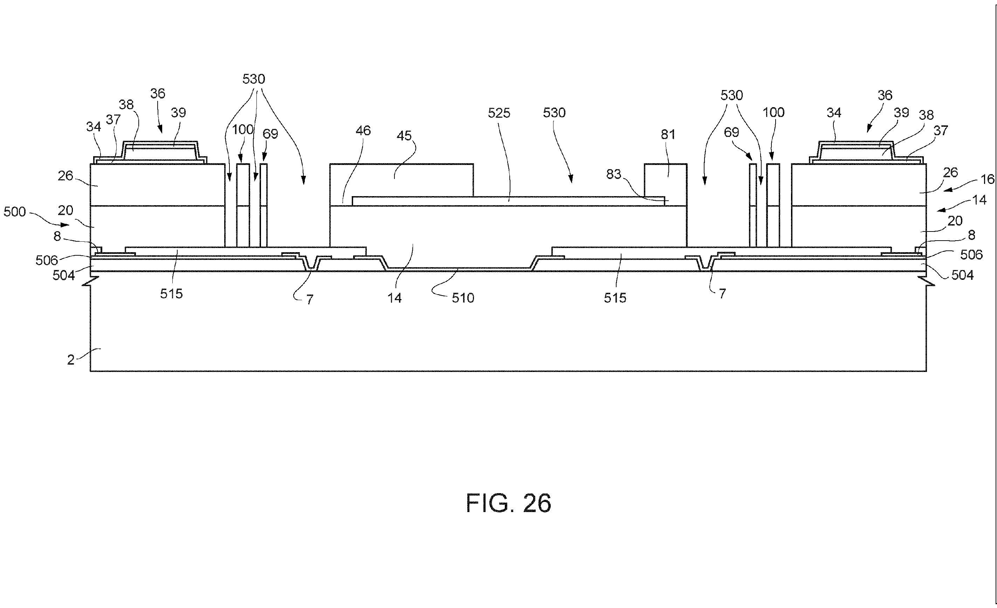

Next, as illustrated in Figure 26, a selective etch is performed using a mask (not illustrated) so as to remove portions of the second semiconductor layer 16 and form process openings 530, which traverse the second semiconductor layer 16 and are delimited at the bottom by corresponding portions of the second sacrificial region 525 or else by corresponding portions of the first sacrificial region 515.

In practice, the process openings 530 that extend as far as the first sacrificial region 515 laterally delimit portions of the second semiconductor layer 16 that form the cantilever structures 29, the coupling bodies 100 and the planar springs 69. The process openings 530 that extend as far as the second sacrificial region 525 laterally delimit portions of the second semiconductor layer 16 that form the main portions 45 of the top shielding regions 40 of the first shielding structures 33 and the main portions 81 of the top secondary regions 77 of the second shielding structures 35.

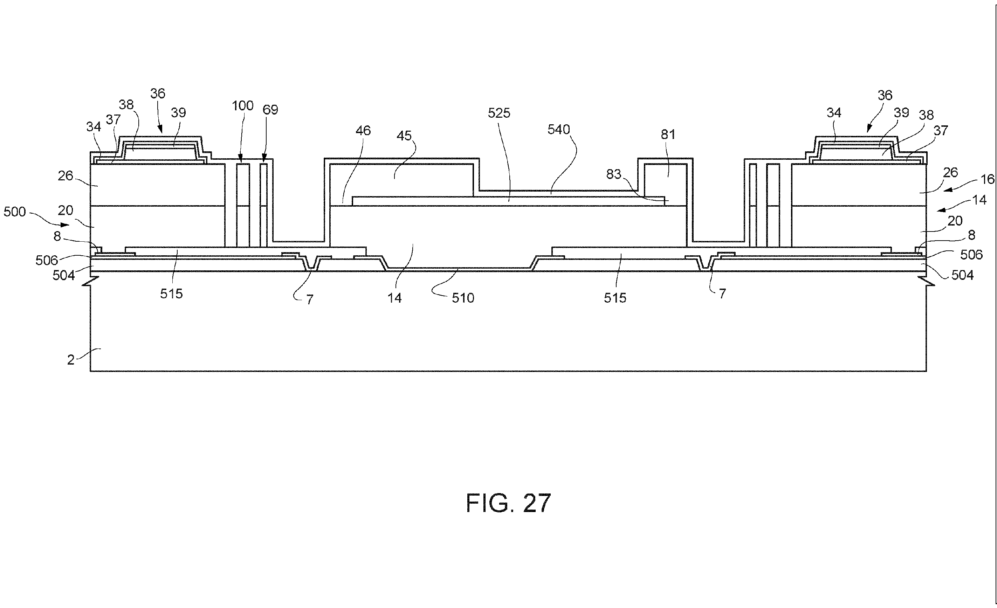

Next, as illustrated in Figure 27, on the semiconductor wafer 500 a protection layer 540 is formed, for example by deposition of TEOS oxide. The protection layer 540 extends on the protective regions 34 of the actuators 36, on the exposed portions of the second semiconductor layer 16, and within the process openings 530 until it contacts portions of the first and second sacrificial regions 515, 525.

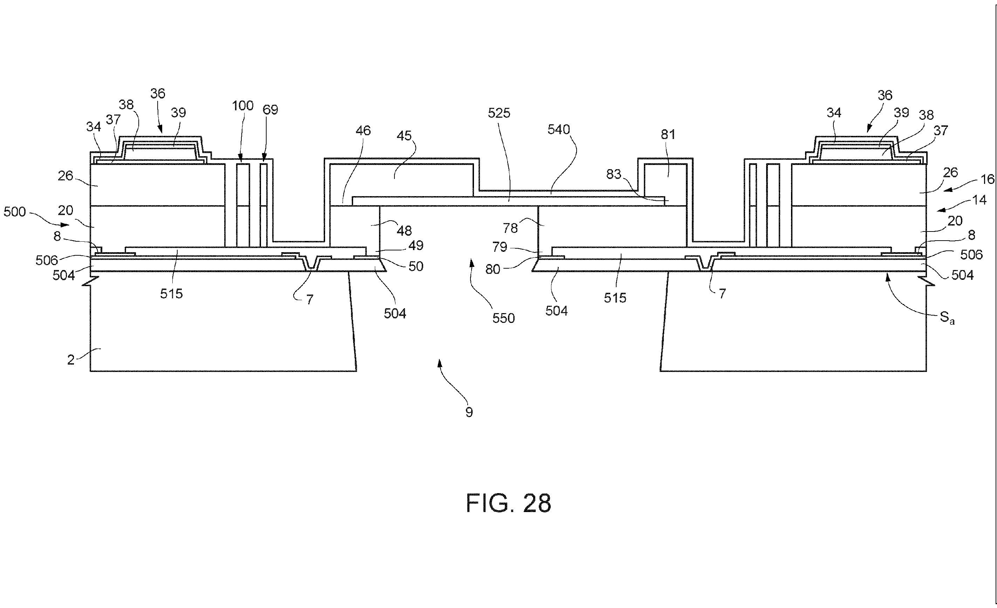

Next, as illustrated in Figure 28, using a respective mask (not illustrated), a backside etch of the substrate 2 is performed, for selective removal of portions of the substrate 2 that are arranged underneath the intermediate conductive region 510 and form the main aperture 9.

In particular, the etch is of a dry type (for example, sulphur hexafluoride is used) and is guided, besides by the aforementioned mask, by the part of the intermediate conductive region 510 that contacts the substrate 2 since etching is not able to remove portions of the first dielectric layer 504. Consequently, in addition to the aforementioned part of the intermediate conductive region 510 that contacts the substrate 2, an overlying portion of the first semiconductor layer 14 is selectively removed. In this way, an intermediate opening 550 is formed, which extends through the first semiconductor layer 14 and the first dielectric layer 504 and communicates with the underlying main aperture 9.

At each of the first shielding structures 33, the intermediate opening 550 is overlaid by a portion of the second sacrificial region 525 arranged underneath the main portion 45 of the corresponding top shielding region 40; this portion of the second sacrificial region 525 enables, in fact, a local etch stop, before the main portion 45 gets damaged.

Furthermore, the etching mask is such that also portions of the substrate 2 are removed that are laterally staggered with respect to the overlying intermediate conductive region 510, said portions being delimited at the top by corresponding portions of the first dielectric layer 504. In this way, the main aperture 9 is partially closed, at the top, by these portions of the first dielectric layer 504, which are laterally staggered with respect to the part of the intermediate conductive region 510 in contact with the substrate 2; these portions of the first dielectric layer 504 are in turn surrounded laterally by the conductive layer 7. In practice, these portions of the first dielectric layer 504 partially close the top mouth of the main aperture 9, understood as the area of the main aperture 9 in the plane of the top surface Sₐ of the substrate 2.

In particular, for each second shielding structure 35, the main aperture 9 is partially occluded by a corresponding portion of the first dielectric layer 504, which is overlaid by a corresponding portion of the first sacrificial region 515 arranged underneath the main portion 78 of the corresponding bottom shielding region 75. The aforesaid corresponding portion of the first dielectric layer 504 protects from etching the corresponding bottom shielding region 75.

At the end of the operations illustrated in Figure 28, the remaining portions of the first semiconductor layer 14 form the bottom secondary regions 42 of the first shielding structures 33 and the bottom shielding regions 75 of the second shielding structures 35. The remaining portions of the intermediate conductive region 510 form the suspended conductive regions 50, 80. In this connection, in Figure 28 it may be noted how the suspended conductive regions 50, 80 project slightly outwards, with respect to the corresponding secondary portions 49, 79; this detail is irrelevant for the purposes of operation of the MEMS shutter 1 and, for simplicity of representation, has not been illustrated in the other figures. Furthermore, the degree of the projection may be much smaller (substantially, negligible) than what is illustrated in Figure 28.

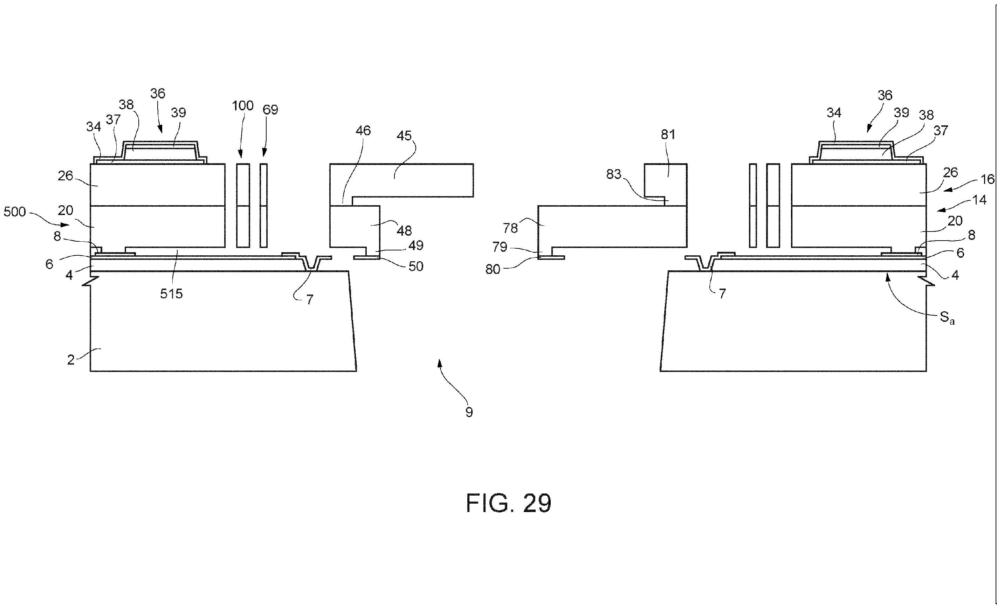

Next, an etch is made using hydrofluoric acid, which enables removal of the protection region 540 and the first and second sacrificial regions 515, 525. Furthermore, the aforementioned portions of the first dielectric layer 504 that in part closed at the top the main aperture 9 are removed. These portions of the first dielectric layer 504 are removed because they are not protected by the aluminium oxide of the second dielectric layer 506. In this way, the first and second shielding structures 33, 35 are released, as well as the corresponding cantilever structures 29 and the corresponding deformable coupling structures 59, thus obtaining what is illustrated in Figure 29. The residual portions of the first and second dielectric layers 504, 506 form, respectively, the first and second dielectric regions 4, 6.

In general, the manufacturing process described may be used for manufacturing also the other embodiments, as for example the embodiments with electrostatic actuation. In particular, formation of the first and second shielding structures 33, 35 and of the coupling bodies is performed in the same way.

The advantages that the present solution afford emerge clearly from the foregoing description.

In particular, the present MEMS shutter 1 may be controlled electrically so as to vary the optical aperture with a large number of degrees of freedom. In fact, it is possible to shield selectively a large number of perimetral portions of the main aperture 9 by rotations of corresponding shielding structures. The fact that the shielding structures are patterned on two different levels enables optimization of the angular arrangement of the shielding structures themselves. In this connection, in general the effect of the movement of the shielding structures on the optical aperture also depends upon the profile of the underlying main aperture 9, which represents a further degree of freedom available to the designer.

Finally, it is clear that modifications and variations may be made to the manufacturing process and to the MEMS shutter described and illustrated herein, without thereby departing from the scope of the present invention, as defined in the annexed claims.

For instance, the shape and arrangement of the shielding structures, the fixed peripheral structure, the cantilever structures, the deformable coupling structures, the coupling bodies, and the stator regions may be different from what has been described.

The number, shape, and arrangement of the pillar regions and the planar springs may be different from what has been described. Likewise, the points of the coupling bodies to which the planar springs are fixed may also vary.

Furthermore, the alignments of the different regions during the manufacturing process may be different from what has been described, for example on account of the typical tolerances of the etching processes.

Once again with reference to the manufacturing process, the polysilicon that forms the first and second semiconductor layers 14, 16 may be obtained in a per se known manner, for example by epitaxial growth starting from exposed portions (not illustrated) of the substrate 2 and of the first semiconductor layer 14, respectively, in order to speed up growth thereof and increase the thicknesses of the first and second semiconductor layers 14, 16. In this connection, in general each one of the first and second semiconductor layers 14, 16 may have a thickness comprised, for example, between 1 µm and 80 µm.

It is further possible for the second dielectric layer 506, and thus the second dielectric region 6, to be made of a material resistant to hydrofluoric acid different from aluminium oxide.

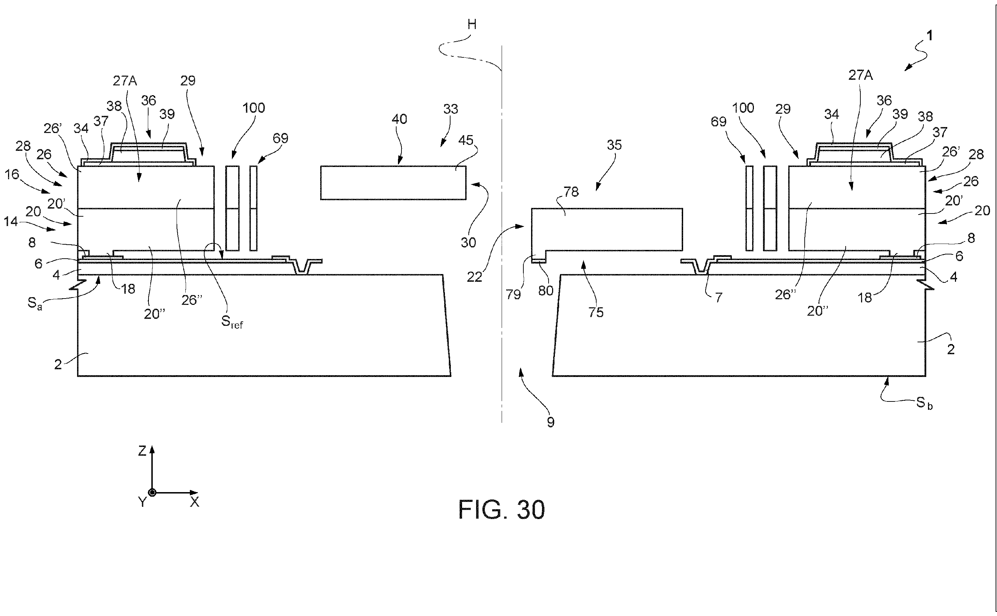

Furthermore, it is possible for the first shielding structures to be formed just by corresponding portions of the second semiconductor layer 16 and/or for the second shielding structures to be formed just by corresponding portions of the first semiconductor layer 14, as illustrated, for example, in Figure 30, where, for instance, it is shown how each first shielding structure 33 is constituted by the main portion 45 of the top shielding region 40; further, each second shielding structure 45 is constituted by the bottom shielding region 75.

Likewise, also the coupling bodies, the deformable coupling structures, and the planar springs may be formed just by portions of one between the first and second semiconductor layers 14, 16; further, the cantilever structures 29 may be formed just by the second semiconductor layer 16.

Finally, the presence of the conductive layer 7 is optional.

## Claims

1. A MEMS shutter comprising:
- a substrate (2) of semiconductor material traversed by a main aperture (9);
- a first semiconductor layer (14), arranged on top of the substrate (2);
- a second semiconductor layer (16), arranged on top of the first semiconductor layer (14) and forming, together with the first semiconductor layer (14), a supporting structure (28, 71) fixed to the substrate (2);
- a plurality of deformable structures (29, 59, 69), each of which is formed by a corresponding portion of at least one of the first semiconductor layer and the second semiconductor layer;
- a plurality of actuators (36; 96); and
- a plurality of shielding structures (33; 35; 333; 335; 433), each of which is formed by a corresponding portion of at least one of the first and second semiconductor layers, the shielding structures being arranged angularly around the underlying main aperture so as to form a shielding of the main aperture, each shielding structure being further mechanically coupled to the supporting structure via a corresponding deformable structure;
and wherein each actuator is electrically controllable so as to cause a rotation of a corresponding shielding structure between a respective first position and a respective second position, thereby varying the shielding of the main aperture; and wherein said first and second positions of the shielding structures are such that, in at least one operating condition of the MEMS shutter (1), pairs of adjacent shielding structures at least partially overlap one another.

2. The MEMS shutter according to claim 1, further comprising a plurality of coupling bodies (100; 100'), each of which is formed by a corresponding portion of at least one of the first and second semiconductor layers (14, 16) and has a first end (104), operatively coupled to a corresponding actuator (36; 96), and a second end (106), fixed to a corresponding shielding structure (33; 35; 333; 335; 433), each actuator (36; 96) being electrically controllable so as to cause a translation of the first end of the corresponding coupling body in a direction parallel to a corresponding direction of translation (R; R'); and wherein each deformable structure (29, 59, 69) forms a corresponding hinge (69, 71) such that the translation of the first end of the corresponding coupling body causes a rotation of the coupling body and of the corresponding shielding structure.

3. The MEMS shutter according to claim 2, wherein each hinge (69, 71) comprises a pair of respective flexural beams (69), each of which has respective ends fixed, respectively, to the corresponding coupling body (100; 100') and to the supporting structure (71).

4. The MEMS shutter according to claim 3, wherein said direction of translation (R; R') is parallel to the substrate (2); and wherein the flexural beams (69) are compliant in a direction parallel to the substrate and are rigid in a direction perpendicular to the substrate in such a way that each coupling body (100; 100') rotates about a corresponding axis of rotation (ROT), which is perpendicular to the substrate.

5. The MEMS shutter according to any one of claims 2 to 4, wherein each deformable structure (29, 59, 69) comprises:
- a cantilever structure (29), fixed to the supporting structure (28, 71); and
- a deformable coupling structure (59), which has its ends fixed to the cantilever structure and to the first end (104) of the corresponding coupling body (100) and is compliant in a direction parallel to an axis (Z) perpendicular to the substrate (2) and in a direction parallel to the direction of translation (R; R') of the corresponding coupling body (100); and
- a constraint structure (69, 71), which mechanically couples the corresponding coupling body to the supporting structure, is rigid along said axis (Z) and is compliant in a plane perpendicular to said axis (Z);
and wherein each actuator (36) is of a piezoelectric type, is coupled to a corresponding cantilever structure (29) and is electrically controllable so as to cause a translation along said axis (Z) of the corresponding cantilever structure (29) and a consequent deformation of the corresponding deformable coupling structure (59), which causes said translation of the first end (104) of the corresponding coupling body (100) in a direction parallel to the corresponding direction of translation.

6. The MEMS shutter according to claim 5, wherein each deformable coupling structure (59) comprises at least one elongated elastic structure (L1), which, in resting conditions, extends in a transverse direction (TR), which is perpendicular to said axis (Z) and to the direction of translation (R; R') of the corresponding coupling body (100) and has, in a plane (ZR) parallel to said axis (Z) and to said direction of translation, a first principal axis of inertia (I1) and a second principal axis of inertia (I2), each of which is transverse with respect to said axis (Z) and to said direction of translation (R; R'), so that movements along said axis (Z) of the end of each deformable coupling structure (59) fixed to the corresponding cantilever structure (29) cause corresponding movements in the respective direction of translation (R; R') of the end of the deformable coupling structure (59) fixed to the first end (104) of the corresponding coupling body (100).

7. The MEMS shutter according to any one of claims 2 to 4, wherein said actuators (96) are of an electrostatic type and each comprise:
- at least one respective stator region (ST1), fixed with respect to the supporting structure (28) and formed by portions of the first and second semiconductor layers (14, 16); and
- at least one respective rotor region (102'), formed by the first end of the corresponding coupling body (100'), the actuator being electrically controllable so as to cause said translation of the first end (104) of the corresponding coupling body (100') in a direction parallel to the corresponding direction of translation.

8. The MEMS shutter according to any one of the preceding claims, wherein said plurality of shielding structures (33; 35; 333; 335; 433) comprises a plurality of first shielding structures (33; 333) and a plurality of second shielding structures (35; 335), which are arranged angularly alternating, each first shielding structure comprising a respective top structure (40; 340), formed by the second semiconductor layer (16), each second shielding structure comprising a respective bottom structure (75; 375), formed by the first semiconductor layer (14); and wherein, when the MEMS shutter (1) is in said at least one operating condition, the top structure of each first shielding structure partially overlaps the bottom structures of the adjacent second shielding structures.

9. The MEMS shutter according to claim 8, wherein each first shielding structure (33; 333) further comprises a respective bottom structure (42; 342), formed by the first semiconductor layer (14), the respective top structure (40; 340) comprising at least one projecting part (45; 345), which projects laterally with respect to said respective bottom structure (42; 342); and wherein each second shielding structure (35; 335) comprises a respective top structure (77; 377), which is formed by the second semiconductor layer (16) and leaves exposed a part (78; 378) of the corresponding bottom structure (75; 375); and wherein, when the MEMS shutter (1) is in said at least one operating condition, the projecting part of the top structure of each first shielding structure overlies at least partially the exposed parts of the bottom structures of the adjacent second shielding structures.

10. The MEMS shutter according to claim 9, wherein, when the MEMS shutter (1) is in said at least one operating condition, the projecting parts (45; 345) of the top structures (40; 340) of the first shielding structures (33; 333) and the exposed parts (78; 378) of the bottom structures (75; 375) of the second shielding structures (35; 335) overlie at least in part the main aperture (9).

11. The MEMS shutter according to claim 9 or claim 10, wherein the top structure (40; 340) of each first shielding structure (33; 333) comprises a top secondary portion (46; 346), fixed with respect to the corresponding underlying bottom structure (42; 342), and a top main portion (45; 345), which extends in cantilever fashion with respect to the top secondary portion and forms said projecting part (45; 345); and wherein the bottom structure (42; 342) of each second shielding structure (35; 335) comprises a bottom main portion (78; 378), which is fixed with respect to the corresponding overlying top structure (77; 377) and forms said exposed part of the bottom structure.

12. The MEMS shutter according to claim 11, wherein the top main portions (45; 345) and the bottom main portions (78; 378) are elongated parallel to corresponding directions of extension (R; R'), which are parallel to the substrate (2).

13. The MEMS shutter according to claim 12, wherein said directions of extension (R) are radial directions.

14. The MEMS shutter according to claim 12, wherein said directions of extension (R') are co-planar and equidistant from an axis of symmetry (H) of the main aperture (9).

15. The MEMS shutter according to any one of claims 1 to 7, wherein the shielding structures (433) each comprise a respective top structure (440), formed by the second semiconductor layer (16), and a respective bottom structure (442), formed by the first semiconductor layer (14); and wherein, when the MEMS shutter (1) is in said at least one operating condition, the top structure of each shielding structure partially overlaps the bottom structure of an adjacent shielding structure.

16. The MEMS shutter according to claim 15, wherein the top structure (440) of each shielding structure (433) comprises a projecting part (481"), which projects laterally with respect to the corresponding bottom structure (442) and leaves exposed a part (448") of the corresponding bottom structure (442); and wherein, when the MEMS shutter (1) is in said at least one operating condition, the projecting part of the top structure of each shielding structure partially overlaps the exposed part of the bottom structure of the adjacent shielding structure.

17. The MEMS shutter according to any one of the preceding claims, wherein the first and second semiconductor layers (14, 16) are made of polysilicon.

18. A process for manufacturing a MEMS shutter (1), comprising:
- forming a first semiconductor layer (14) on top of a substrate (2) of semiconductor material;
- forming on top of the first semiconductor layer (14) a second semiconductor layer (16), which forms, with the first semiconductor layer (14), a supporting structure (28, 71) fixed to the substrate;
- forming a plurality of deformable structures (29, 59, 69), each of which is formed by a corresponding portion of at least one of the first and second semiconductor layers;
- forming a main aperture (9) through the substrate;
- forming a plurality of actuators (36; 96); and
- forming a plurality of shielding structures (33; 35; 333; 335; 433), each of which is formed by a corresponding portion of at least one of the first and second semiconductor layers, the shielding structures being arranged angularly around the underlying main aperture so as to form a shielding of the main aperture, each shielding structure being further mechanically coupled to the supporting structure via a corresponding deformable structure;
and wherein each actuator is electrically controllable so as to cause a rotation of a corresponding shielding structure between a respective first position and a respective second position, thereby varying the shielding of the main aperture; and wherein said first and second positions of the shielding structures are such that, in at least one operating condition of the MEMS shutter (1), pairs of adjacent shielding structures at least partially overlap one another.

19. The manufacturing process according to claim 18, further comprising forming a plurality of coupling bodies (100; 100'), each of which is formed by a corresponding portion of at least one of the first and second semiconductor layers (14, 16) and has a first end (104), operatively coupled to a corresponding actuator (36; 96), and a second end (106), fixed to a corresponding shielding structure (33; 35; 333; 335; 433), each actuator (36; 96) being electrically controllable so as to cause a translation of the first end of the corresponding coupling body in a direction parallel to a corresponding direction of translation (R; R'); and wherein each deformable structure (29, 59, 69) forms a corresponding hinge (69, 71) such that the translation of the first end of the corresponding coupling body causes a rotation of the coupling body and of the corresponding shielding structure.

20. The manufacturing process according to claim 18 or claim 19, further comprising:
- forming on the substrate (2) a layered region (504, 506) of dielectric material;
- selectively removing portions of the layered region (504, 506) and exposing a portion of the substrate (2);
- forming on the exposed portion of the substrate (2) an intermediate conductive region (510);
- forming a first sacrificial dielectric region (515) on the layered region (504, 506) and on the intermediate conductive region (510);
- selectively removing portions of the first sacrificial dielectric region (515) so as to expose the intermediate conductive region (510);
- forming the first semiconductor layer (14) on the first sacrificial dielectric region (515) and on the intermediate conductive region (510);
- forming a second sacrificial dielectric region (525) on the first semiconductor layer (14) so that it overlies at a distance at least part of the intermediate conductive region (510);
- forming the second semiconductor layer (16) on the second sacrificial dielectric region (525); and
- selectively removing portions of the second semiconductor layer (16) so as to form top openings (530) that traverse the second semiconductor layer (16) and laterally delimit at least in part the shielding structures (33);
and wherein forming the main aperture (9) comprises selectively removing: portions of the substrate (2) arranged in contact with the intermediate conductive region (510); the intermediate conductive region (510); portions of the first semiconductor layer (14) that overlie the intermediate conductive region (510) and are overlaid by corresponding portions of the second sacrificial dielectric region (525), said corresponding portions of the second sacrificial dielectric region (525) being overlaid by corresponding portions (45) of the shielding structures (33); and portions of the substrate (2) that are laterally staggered with respect to the intermediate conductive region (510) and are delimited at the top by portions (504) of the layered region (504, 506) that are laterally staggered with respect to the intermediate conductive region (510), which are overlaid by corresponding portions of the first sacrificial dielectric region (515), said corresponding portions of the first sacrificial dielectric region (515) being overlaid by corresponding portions (78) of the shielding structures (35);
said process further comprising removing the first and second sacrificial dielectric regions (515, 525) and said portions of the layered region (504, 506) that are laterally staggered with respect to the intermediate conductive region (510) so as to release the shielding structures.

21. The manufacturing process according to claim 20, further comprising:
- patterning the second sacrificial dielectric region (525) so as to expose portions of the first semiconductor layer (14); and
- forming the second semiconductor layer (16) so that it contacts the exposed portions of the first semiconductor layer (14); and
- selectively removing portions of the second semiconductor layer (16) and underlying portions of the first semiconductor layer (14) so as to form additional openings (530) that laterally delimit the deformable structures (29, 69) at least in part.

22. The manufacturing process according to claim 20 or claim 21, wherein forming the layered region (504, 506) comprises:
- forming on the substrate (2) a first dielectric layer (504); and
- forming on the first dielectric layer (504) a second dielectric layer (506) resistant to a chemical agent;
and wherein selectively removing portions of the layered region (504, 506) comprises:
- selectively removing portions of the second dielectric layer (506) so as to expose a part of the first dielectric layer (504); and then
- removing portions of the exposed part of the first dielectric layer (504) so as to expose said portion of the substrate (2);
and wherein forming the first sacrificial dielectric region (515) comprises forming the first sacrificial dielectric region (515) on portions of the exposed part of the first dielectric layer (504) that are laterally staggered with respect to the intermediate conductive region (510); and wherein said portions (504) of the layered region (504, 506) that are laterally staggered with respect to the intermediate conductive region (510) comprise said portions of the exposed part of the first dielectric layer (504) that are laterally staggered with respect to the intermediate conductive region (510); and wherein removing the first and second sacrificial dielectric regions (515, 525) and said portions of the layered region (504, 506) that are laterally staggered with respect to the intermediate conductive region (510) comprises carrying out an etch with said chemical agent.

23. The manufacturing process according to any one of claims 18 to 22, comprising forming, on the layered region (504, 506), conductive anchorage regions (8) that are laterally staggered with respect to the intermediate conductive region (510); and wherein forming the first sacrificial dielectric region (515) comprises forming the first sacrificial dielectric region (515) on the conductive anchorage regions (8); said process further comprising removing additional portions of the first sacrificial dielectric region (515) so as to expose the conductive anchorage regions (8); and wherein forming the first semiconductor layer (14) comprises forming the first semiconductor layer (14) on the conductive anchorage regions (8).

## Patentansprüche

1. MEMS-Verschluss, umfassend:
- ein Substrat (2) aus Halbleitermaterial, das von einer Hauptöffnung (9) durchquert wird;
- eine erste Halbleiterschicht (14), die oben auf dem Substrat (2) angeordnet ist,
- eine zweite Halbleiterschicht (16), die oben auf der ersten Halbleiterschicht (14) angeordnet ist, und zusammen mit der ersten Halbleiterschicht (14) eine Trägerstruktur (28, 71) bildet, die an dem Substrat (2) fixiert ist;
- eine Vielzahl von verformbaren Strukturen (29, 59, 69), von denen jede durch einen entsprechenden Abschnitt von mindestens einer von der ersten Halbleiterschicht und der zweiten Halbleiterschicht gebildet wird;
- eine Vielzahl von Stellantrieben (36, 96); und
- eine Vielzahl von Abschirmstrukturen (33; 35; 333; 335; 433), von denen jede durch einen entsprechenden Abschnitt von mindestens einer der ersten und zweiten Halbleiterschicht gebildet wird, wobei die Abschirmstrukturen winkelig um die darunterliegende Hauptöffnung herum angeordnet sind, um eine Abschirmung der Hauptöffnung zu bilden, wobei jede Abschirmstruktur weiter über eine entsprechende verformbare Struktur mechanisch mit der Trägerstruktur gekoppelt ist;
und wobei jeder Stellantrieb elektrisch steuerbar ist, um eine Drehung einer entsprechenden Abschirmstruktur zwischen einer jeweiligen ersten Position und einer jeweiligen zweiten Position zu veranlassen, wodurch die Abschirmung der Hauptöffnung variiert; und wobei die erste und zweite Position der Abschirmstrukturen derart sind, dass unter mindestens einer Betriebsbedingung des MEMS-Verschlusses (1) Paare benachbarter Abschirmstrukturen einander mindestens teilweise überlappen.

2. MEMS-Verschluss nach Anspruch 1, der weiter eine Vielzahl von Kopplungskörpern (100; 100') umfasst, von denen jeder durch einen entsprechenden Abschnitt von mindestens einer der ersten und zweiten Halbleiterschicht (14, 16) gebildet ist, und ein erstes Ende (104), das betrieblich mit einem entsprechenden Stellantrieb (36; 96) gekoppelt ist, und ein zweites Ende (106), das an einer entsprechenden Abschirmstruktur (33; 35; 333; 335; 433) fixiert ist, aufweist, wobei jeder Stellantrieb (36; 96) elektrisch steuerbar ist, um eine Translation des ersten Endes des entsprechenden Kopplungskörpers in einer Richtung parallel zu einer entsprechenden Translationsrichtung (R; R') zu veranlassen; und wobei jede verformbare Struktur (29, 59, 69) ein entsprechendes Gelenk (69, 71) bildet, sodass die Translation des ersten Endes des entsprechenden Kopplungskörpers eine Drehung des Kopplungskörpers und der entsprechenden Abschirmstruktur veranlasst.

3. MEMS-Verschluss nach Anspruch 2, wobei jedes Gelenk (69, 71) ein Paar jeweiliger Biegebalken (69) umfasst, von denen jeder jeweilige Enden aufweist, die jeweils an dem entsprechenden Kopplungskörper (100; 100') und an der Trägerstruktur (71) fixiert sind.

4. MEMS-Verschluss nach Anspruch 3, wobei die Translationsrichtung (R; R') parallel zum Substrat (2) verläuft; und wobei die Biegebalken (69) in einer Richtung parallel zum Substrat nachgiebig sind, und in einer Richtung senkrecht zum Substrat starr sind, sodass sich jeder Kopplungskörper (100; 100') um eine entsprechende Drehachse (ROT) dreht, die senkrecht zum Substrat verläuft.

5. MEMS-Verschluss nach einem der Ansprüche 2 bis 4, wobei jede verformbare Struktur (29, 59, 69) umfasst:
- eine Auslegerstruktur (29), die an der Trägerstruktur (28, 71) fixiert ist; und
- eine verformbare Kopplungsstruktur (59), deren Enden an der Auslegerstruktur und an dem ersten Ende (104) des entsprechenden Kopplungskörpers (100) fixiert sind, und in einer Richtung parallel zu einer Achse (Z) senkrecht zum Substrat (2), und in einer Richtung parallel zur Translationsrichtung (R; R') des entsprechenden Kopplungskörpers (100) nachgiebig sind; und
- eine Einschränkungsstruktur (69, 71), die den entsprechenden Kopplungskörper mechanisch mit der Trägerstruktur koppelt, entlang der Achse (Z) starr ist, und in einer Ebene senkrecht zur Achse (Z) nachgiebig ist; und wobei jeder Stellantrieb (36) von einem piezoelektrischen Typ ist, mit einer entsprechenden Auslegerstruktur (29) gekoppelt ist, und elektrisch steuerbar ist, um eine Translation entlang der Achse (Z) der entsprechenden Auslegerstruktur (29) und eine daraus folgende Verformung der entsprechenden verformbaren Kopplungsstruktur (59) zu veranlassen, welche die Translation des ersten Endes (104) des entsprechenden Kopplungskörpers (100) in einer Richtung parallel zur entsprechenden Translationsrichtung veranlasst.

6. MEMS-Verschluss nach Anspruch 5, wobei jede verformbare Kopplungsstruktur (59) mindestens eine längliche elastische Struktur (L1) umfasst, die sich, unter Ruhebedingungen, in einer Querrichtung (TR) erstreckt, die senkrecht zur Achse (Z) und zur Translationsrichtung (R; R') des entsprechenden Kopplungskörpers (100) verläuft, und in einer Ebene (ZR) parallel zur Achse (Z) und zur Translationsrichtung eine erste Hauptträgheitsachse (I1) und eine zweite Hauptträgheitsachse (I2) aufweist, von denen jede in Bezug auf die Achse (Z) und die Translationsrichtung (R; R') querlaufend ist, sodass Bewegungen entlang der Achse (Z) des Endes einer jeden verformbaren Kopplungsstruktur (59), die an der entsprechenden Auslegerstruktur (29) fixiert ist, entsprechende Bewegungen in der jeweiligen Translationsrichtung (R; R') des Endes der verformbaren Kopplungsstruktur (59) veranlasst, die am ersten Ende (104) des entsprechenden Kopplungskörpers (100) fixiert ist.

7. MEMS-Verschluss nach einem der Ansprüche 2 bis 4, wobei die Stellantriebe (96) von einem elektrostatischen Typ sind und jeweils umfassen:
- mindestens einen jeweiligen Statorbereich (ST1), der in Bezug auf die Trägerstruktur (28) fixiert, und durch Abschnitte der ersten und zweiten Halbleiterschicht (14, 16) gebildet ist; und
- mindestens einen jeweiligen Rotorbereich (102'), der durch das erste Ende des entsprechenden Kopplungskörpers (100') gebildet wird, wobei der Stellantrieb elektrisch steuerbar ist, um die Translation des ersten Endes (104) des entsprechenden Kopplungskörpers (100') in einer Richtung parallel zur entsprechenden Translationsrichtung zu veranlassen.

8. MEMS-Verschluss nach einem der vorstehenden Ansprüche, wobei die Vielzahl von Abschirmstrukturen (33; 35; 333; 335; 433) eine Vielzahl von ersten Abschirmstrukturen (33; 333) und eine Vielzahl von zweiten Abschirmstrukturen (35; 335) umfasst, die im Winkel abwechselnd angeordnet sind, wobei jede erste Abschirmstruktur eine jeweilige obere Struktur (40; 340) umfasst, die durch die zweite Halbleiterschicht (16) gebildet wird, jede zweite Abschirmstruktur eine jeweilige untere Struktur (75; 375) umfasst, die durch die erste Halbleiterschicht (14) gebildet wird; und wobei, wenn der MEMS-Verschluss (1) unter der mindestens einen Betriebsbedingung ist, die obere Struktur jeder ersten Abschirmstruktur die unteren Strukturen der benachbarten zweiten Abschirmstrukturen teilweise überlappt.

9. MEMS-Verschluss nach Anspruch 8, wobei jede erste Abschirmstruktur (33; 333) weiter eine jeweilige untere Struktur (42; 342) umfasst, die durch die erste Halbleiterschicht (14) gebildet wird, die jeweilige obere Struktur (40; 340) mindestens einen vorstehenden Teil (45; 345) umfasst, der in Bezug auf die jeweilige untere Struktur (42; 342) seitlich vorsteht; und wobei jede zweite Abschirmstruktur (35; 335) eine jeweilige obere Struktur (77; 377) umfasst, die durch die zweite Halbleiterschicht (16) gebildet ist, und einen Teil (78; 378) der entsprechenden unteren Struktur (75; 375) freigelegt lässt; und wobei, wenn der MEMS-Verschluss (1) unter der mindestens einen Betriebsbedingung ist, der vorstehende Teil der oberen Struktur jeder ersten Abschirmstruktur mindestens teilweise über den freigelegten Teilen der unteren Strukturen der benachbarten zweiten Abschirmstrukturen liegt.

10. MEMS-Verschluss nach Anspruch 9, wobei, wenn der MEMS-Verschluss (1) unter der mindestens einen Betriebsbedingung ist, die vorstehenden Teile (45; 345) der oberen Strukturen (40; 340) der ersten Abschirmstrukturen (33; 333) und die freigelegten Teile (78; 378) der unteren Strukturen (75; 375) der zweiten Abschirmstrukturen (35; 335) mindestens teilweise über der Hauptöffnung (9) liegen.

11. MEMS-Verschluss nach Anspruch 9 oder Anspruch 10, wobei die obere Struktur (40; 340) der ersten Abschirmstruktur (33; 333) einen oberen Sekundärabschnitt (46; 346), der in Bezug auf die entsprechende darunterliegende untere Struktur (42; 342) fixiert ist, und einen oberen Hauptabschnitt (45; 345), der sich in der Art eines Auslegers in Bezug auf den oberen Sekundärabschnitt erstreckt, und den vorstehenden Teil (45; 345) bildet, umfasst; und wobei die untere Struktur (42; 342) jeder zweiten Abschirmstruktur (35; 335) einen unteren Hauptabschnitt (78; 378), der in Bezug auf die entsprechende darüberliegende obere Struktur (77; 377) fixiert ist, und den freigelegten Teil der unteren Struktur bildet, umfasst.

12. MEMS-Verschluss nach Anspruch 11, wobei die oberen Hauptabschnitte (45; 345) und die unteren Hauptabschnitte (78; 378) länglich parallel zu entsprechenden Erstreckungsrichtungen (R; R') verlaufen, die parallel zum Substrat (2) verlaufen.

13. MEMS-Verschluss nach Anspruch 12, wobei die Erstreckungsrichtungen (R) radiale Richtungen sind.

14. MEMS-Verschluss nach Anspruch 12, wobei die Erstreckungsrichtungen (R') komplanar und im gleichen Abstand von einer Symmetrieachse (H) der Hauptöffnung (9) sind.

15. MEMS-Verschluss nach einem der Ansprüche 1 bis 7, wobei die Abschirmstrukturen (433) jeweils eine jeweilige obere Struktur (440), die durch die zweite Halbleiterschicht (16) gebildet wird, und eine jeweilige untere Struktur (442), die durch die erste Halbleiterschicht (14) gebildet wird, umfassen; und wobei, wenn der MEMS-Verschluss (1) unter der mindestens einen Betriebsbedingung ist, die obere Struktur jeder Abschirmstruktur die untere Struktur einer benachbarten Abschirmstruktur teilweise überlappt.

16. MEMS-Verschluss nach Anspruch 15, wobei die obere Struktur (440) einer jeden Abschirmstruktur (433) einen vorstehenden Teil (481'') umfasst, der seitlich in Bezug auf die entsprechende untere Struktur (442) vorsteht, und einen Teil (448'') der entsprechenden unteren Struktur (442) freigelegt lässt; und wobei, wenn der MEMS-Verschluss (1) unter der mindestens einen Betriebsbedingung ist, der vorstehende Teil der oberen Struktur jeder Abschirmstruktur den freigelegten Teil der unteren Struktur der benachbarten Abschirmstruktur teilweise überlappt.

17. MEMS-Verschluss nach einem der vorstehenden Ansprüche, wobei die erste und zweite Halbleiterschicht (14, 16) aus Polysilizium gefertigt sind.

18. Verfahren zur Herstellung eines MEMS-Verschlusses (1), umfassend:
- Bilden einer ersten Halbleiterschicht (14) oben auf einem Substrat (2) aus Halbleitermaterial,
- Bilden oben auf der ersten Halbleiterschicht (14) einer zweiten Halbleiterschicht (16), die mit der ersten Halbleiterschicht (14) eine Trägerstruktur (28, 71) bildet, die an dem Substrat fixiert ist;
- Bilden einer Vielzahl von verformbaren Strukturen (29, 59, 69), von denen jede durch einen entsprechenden Abschnitt von mindestens einer von der ersten Halbleiterschicht und der zweiten Halbleiterschicht gebildet wird;
- Bilden einer Hauptöffnung (9) durch das Substrat hindurch;
- Bilden einer Vielzahl von Stellantrieben (36, 96); und
- Bilden einer Vielzahl von Abschirmstrukturen (33; 35; 333; 335; 433), von denen jede durch einen entsprechenden Abschnitt von mindestens einer der ersten und zweiten Halbleiterschicht gebildet wird, wobei die Abschirmstrukturen im Winkel um die darunterliegende Hauptöffnung herum angeordnet sind, um eine Abschirmung der Hauptöffnung zu bilden, wobei jede Abschirmstruktur weiter über eine entsprechende verformbare Struktur mechanisch mit der Trägerstruktur gekoppelt ist;
und wobei jeder Stellantrieb elektrisch steuerbar ist, um eine Drehung einer entsprechenden Abschirmstruktur zwischen einer jeweiligen ersten Position und einer jeweiligen zweiten Position zu veranlassen, wodurch die Abschirmung der Hauptöffnung variiert; und wobei die erste und zweite Position der Abschirmstrukturen derart sind, dass unter mindestens einer Betriebsbedingung des MEMS-Verschlusses (1) Paare benachbarter Abschirmstrukturen einander mindestens teilweise überlappen.

19. Herstellungsverfahren nach Anspruch 18, das weiter das Bilden einer Vielzahl von Kopplungskörpern (100; 100') umfasst, von denen jeder durch einen entsprechenden Abschnitt von mindestens einer der ersten und zweiten Halbleiterschicht (14, 16) gebildet ist, und ein erstes Ende (104), das betrieblich mit einem entsprechenden Stellantrieb (36; 96) gekoppelt ist, und ein zweites Ende (106), das an einer entsprechenden Abschirmstruktur (33; 35; 333; 335; 433) fixiert ist, aufweist, wobei jeder Stellantrieb (36; 96) elektrisch steuerbar ist, um eine Translation des ersten Endes des entsprechenden Kopplungskörpers in einer Richtung parallel zu einer entsprechenden Translationsrichtung (R; R') zu veranlassen; und wobei jede verformbare Struktur (29, 59, 69) ein entsprechendes Gelenk (69, 71) bildet, sodass die Translation des ersten Endes des entsprechenden Kopplungskörpers eine Drehung des Kopplungskörpers und der entsprechenden Abschirmstruktur veranlasst.

20. Herstellungsverfahren nach Anspruch 18 oder Anspruch 19, weiter umfassend:
- Bilden auf dem Substrat (2) eines geschichteten Bereichs (504, 506) aus dielektrischem Material;
- selektiv Entfernen von Abschnitten des geschichteten Bereichs (504, 506) und Freilegen eines Abschnitts des Substrats (2);
- Bilden auf dem freigelegten Abschnitt des Substrats (2) eines leitenden Zwischenbereichs (510);
- Bilden eines ersten dielektrischen Opferbereichs (515) auf dem geschichteten Bereich (504, 506) und auf dem leitenden Zwischenbereich (510);
- selektiv Entfernen von Abschnitten des ersten dielektrischen Opferbereichs (515), um den leitenden Zwischenbereich (510) freizulegen;
- Bilden der ersten Halbleiterschicht (14) auf dem ersten dielektrischen Opferbereich (515) und auf dem leitenden Zwischenbereich (510);
- Bilden eines zweiten dielektrischen Opferbereichs (525) auf der ersten Halbleiterschicht (14), sodass er in einem Abstand über mindestens einem Teil des leitenden Zwischenbereichs (510) liegt;
- Bilden der zweiten Halbleiterschicht (16) auf dem zweiten dielektrischen Opferbereich (525); und
- selektiv Entfernen von Abschnitten der zweiten Halbleiterschicht (16), um obere Löcher (530) zu bilden, welche die zweite Halbleiterschicht (16) durchqueren und die Abschirmstrukturen (33) seitlich mindestens teilweise begrenzen;
und wobei Bilden der Hauptöffnung (9) selektiv Entfernen umfasst von: Abschnitten des Substrats (2), die in Kontakt mit dem leitenden Zwischenbereich (510) angeordnet sind; dem leitenden Zwischenbereich (510); Abschnitten der ersten Halbleiterschicht (14), die über dem leitenden Zwischenbereich (510) liegen, und über denen entsprechende Abschnitte des zweiten dielektrischen Opferbereichs (525) liegen, wobei über den entsprechenden Abschnitten des zweiten dielektrischen Opferbereichs (525) entsprechende Abschnitte (45) der Abschirmstrukturen (33) liegen; Abschnitten des Substrats (2), die in Bezug auf den leitenden Zwischenbereich (510) seitlich versetzt sind, und oben durch Abschnitte (504) des geschichteten Bereichs (504, 506) begrenzt sind, die in Bezug auf den leitenden Zwischenbereich (510) seitlich versetzt sind, über denen entsprechende Abschnitte des ersten dielektrischen Opferbereichs (515) liegen, wobei über den entsprechenden Abschnitten des ersten dielektrischen Opferbereichs (515) entsprechende Abschnitte (78) der Abschirmstrukturen (35) liegen;
wobei das Verfahren weiter Entfernen des ersten und zweiten dielektrischen Opferbereichs (515, 525) und der Abschnitte des geschichteten Bereichs (504, 506) umfasst, die in Bezug auf den leitenden Zwischenbereich (510) seitlich versetzt sind, um die Abschirmstrukturen freizugeben.

21. Herstellungsverfahren nach Anspruch 20, weiter umfassend:
- Mustern des zweiten dielektrischen Opferbereichs (525), um Abschnitte der ersten Halbleiterschicht (14) freizulegen; und
- Bilden der zweiten Halbleiterschicht (16), sodass sie die freigelegten Abschnitte der ersten Halbleiterschicht (14) berührt; und
- selektiv Entfernen von Abschnitten der zweiten Halbleiterschicht (16) und darunterliegenden Abschnitten der ersten Halbleiterschicht (14), um zusätzliche Löcher (530) zu bilden, welche die verformbaren Strukturen (29, 69) mindestens teilweise seitlich begrenzen.

22. Herstellungsverfahren nach Anspruch 20 oder Anspruch 21, wobei Bilden des geschichteten Bereichs (504, 506) umfasst:
- Bilden auf dem Substrat (2) einer ersten dielektrischen Schicht (504); und
- Bilden auf der ersten dielektrischen Schicht (504) einer zweiten dielektrischen Schicht (506), die einer Chemikalie standhält;
und wobei selektiv Entfernen von Abschnitten des geschichteten Bereichs (504, 506) umfasst:
- selektiv Entfernen von Abschnitten der zweiten dielektrischen Schicht (506), um einen Teil der ersten dielektrischen Schicht (504) freizulegen; und danach
- Entfernen von Abschnitten des freigelegten Teils der ersten dielektrischen Schicht (504), um den Abschnitt des Substrats (2) freizulegen;
und wobei Bilden des ersten dielektrischen Opferbereichs (515) Bilden des ersten dielektrischen Opferbereichs (515) auf Abschnitten des freigelegten Teils der ersten dielektrischen Schicht (504), die in Bezug auf den leitenden Zwischenbereich (510) seitlich versetzt sind, umfasst; und wobei die Abschnitte (504) des geschichteten Bereichs (504, 506), die in Bezug auf den leitenden Zwischenbereich (510) seitlich versetzt sind, die Abschnitte des freigelegten Teils der ersten dielektrischen Schicht (504) umfassen, die in Bezug auf den leitenden Zwischenbereich (510) seitlich versetzt sind; und wobei Entfernen des ersten und zweiten dielektrischen Opferbereichs (515, 525) und der Abschnitte des geschichteten Bereichs (504, 506), die in Bezug auf den leitenden Zwischenbereich (510) seitlich versetzt sind, das Ausführen einer Ätzung mit der Chemikalie umfasst.

23. Herstellungsverfahren nach einem der Ansprüche 18 bis 22, welches das Bilden auf dem geschichteten Bereich (504, 506) von leitenden Verankerungsbereichen (8) umfasst, die in Bezug auf den leitenden Zwischenbereich (510) seitlich versetzt sind; und wobei Bilden des ersten dielektrischen Opferbereichs (515) Bilden des ersten dielektrischen Opferbereichs (515) auf den leitenden Verankerungsbereichen (8) umfasst; wobei das Verfahren weiter Entfernen zusätzlicher Abschnitte des ersten dielektrischen Opferbereichs (515) umfasst, um die leitenden Verankerungsbereiche (8) freizulegen; und wobei Bilden der ersten Halbleiterschicht (14) Bilden der ersten Halbleiterschicht (14) auf den leitenden Verankerungsbereichen (8) umfasst.

## Revendications

1. Obturateur MEMS comprenant :
- un substrat (2) en matériau semi-conducteur traversé par une ouverture principale (9) ;
- une première couche semi-conductrice (14), agencée sur le dessus du substrat (2) ;
- une deuxième couche semi-conductrice (16), agencée sur le dessus de la première couche semi-conductrice (14) et formant, conjointement avec la première couche semi-conductrice (14), une structure de support (28, 71) fixée au substrat (2) ;
- une pluralité de structures déformables (29, 59, 69), dont chacune est formée par une portion correspondante d'au moins une de la première couche semi-conductrice et de la deuxième couche semi-conductrice ;
- une pluralité d'actionneurs (36 ; 96) ; et
- une pluralité de structures de masquage (33 ; 35 ; 333 ; 335 ; 433), dont chacune est formée par une portion correspondante d'au moins une des première et deuxième couches semi-conductrices, les structures de masquage étant agencées angulairement autour de l'ouverture principale sous-jacente de façon à assurer un masquage de l'ouverture principale, chaque structure de masquage étant en outre couplée mécaniquement à la structure de support par l'intermédiaire d'une structure déformable correspondante ;
et dans lequel chaque actionneur est commandable électriquement de façon à provoquer une rotation d'une structure de masquage correspondante entre une première position respective et une deuxième position respective, faisant ainsi varier le masquage de l'ouverture principale ; et dans lequel lesdites première et deuxième positions des structures de masquage sont telles que, dans au moins une condition de fonctionnement de l'obturateur MEMS (1), des paires de structures de masquage adjacentes se chevauchent au moins partiellement.

2. Obturateur MEMS selon la revendication 1, comprenant en outre une pluralité de corps de couplage (100; 100'), dont chacun est formé par une portion correspondante d'au moins une des première et deuxième couches semi-conductrices (14, 16) et a une première extrémité (104), couplée fonctionnellement à un actionneur correspondant (36 ; 96), et une deuxième extrémité (106), fixée à une structure de masquage correspondante (33 ; 35 ; 333 ; 335 ; 433), chaque actionneur (36 ; 96) étant commandable électriquement de façon à provoquer une translation de la première extrémité du corps de couplage correspondant dans une direction parallèle à une direction de translation correspondante (R ; R') ; et dans lequel chaque structure déformable (29, 59, 69) forme une charnière correspondante (69, 71) de sorte que la translation de la première extrémité du corps de couplage correspondant provoque une rotation du corps de couplage et de la structure de masquage correspondante.

3. Obturateur MEMS selon la revendication 2, dans lequel chaque charnière (69, 71) comprend une paire de poutres de flexion respectives (69), dont chaque a des extrémités fixées, respectivement, au corps de couplage correspondant (100, 100') et à la structure de support (71).

4. Obturateur MEMS selon la revendication 3, dans lequel ladite direction de translation (R ; R') est parallèle au substrat (2) ; et dans lequel les poutres de flexion (69) sont flexibles dans une direction parallèle au substrat et sont rigides dans une direction perpendiculaire au substrat de telle sorte que chaque corps de couplage (100 ; 100') tourne autour d'un axe de rotation correspondant (ROT), qui est perpendiculaire au substrat.

5. Obturateur MEMS selon n'importe laquelle des revendications 2 à 4, dans lequel chaque structure déformable (29, 59, 69) comprend :
- une structure en porte-à-faux (29), fixée à la structure de support (28, 71) ; et
- une structure de couplage déformable (59), qui a ses extrémités fixées à la structure en porte-à-faux et à la première extrémité (104) du corps de couplage correspondant (100) et est flexible dans une direction parallèle à un axe (Z) perpendiculaire au substrat (2) et dans une direction parallèle à la direction de translation (R ; R') du corps de couplage correspondant (100) ; et
- une structure de contrainte (69, 71), qui couple mécaniquement le corps de couplage correspondant à la structure de support, est rigide le long dudit axe (Z) et est flexible dans un plan perpendiculaire audit axe (Z) ;
et dans lequel chaque actionneur (36) est d'un type piézoélectrique, est couplé à une structure en porte-à-faux correspondante (29) et est commandable électriquement de façon à provoquer une translation le long dudit axe (Z) de la structure en porte-à-faux correspondante (29) et une déformation conséquente de la structure de couplage déformable correspondante (59), qui provoque ladite translation de la première extrémité (104) du corps de couplage correspondant (100) dans une direction parallèle à la direction de translation correspondante.

6. Obturateur MEMS selon la revendication 5, dans lequel chaque structure de couplage déformable (59) comprend au moins une structure élastique allongée (L1), qui, dans des conditions de repos, s'étend dans une direction transversale (TR), qui est perpendiculaire audit axe (Z) et à la direction de translation (R ; R') du corps de couplage correspondant (100) et a, dans un plan (ZR) parallèle audit axe (Z) et à ladite direction de translation, un premier axe d'inertie principal (I1) et un deuxième axe d'inertie principal (I2), dont chacun est transversal par rapport audit axe (Z) et à ladite direction de translation (R ; R'), de façon que des mouvements le long dudit axe (Z) de l'extrémité de chaque structure de couplage déformable (59) fixée à la structure en porte-à-faux correspondante (29) provoquent des mouvements correspondants dans la direction de translation respective (R ; R') de l'extrémité de la structure de couplage déformable (59) fixée à la première extrémité (104) du corps de couplage correspondant (100).

7. Obturateur MEMS selon n'importe laquelle des revendications 2 à 4, dans lequel lesdits actionneurs (96) sont d'un type électrostatique et comprennent chacun :
- au moins une région de stator respective (ST1), fixe par rapport à la structure de support (28) et formée par des portions des première et deuxième couches semi-conductrices (14, 16) ; et
- au moins une région de rotor respective (102'), formée par la première extrémité du corps de couplage correspondant (100'), l' actionneur étant commandable électriquement de façon à provoquer ladite translation de la première extrémité (104) du corps de couplage correspondant (100') dans une direction parallèle à la direction de translation correspondante.

8. Obturateur MEMS selon n'importe laquelle des revendications précédentes, dans lequel ladite pluralité de structures de masquage (33 ; 35 ; 333 ; 335 ; 433) comprend une pluralité de premières structures de masquage (33 ; 333) et une pluralité de deuxièmes structures de masquage (35 ; 335), qui sont agencées alternées angulairement, chaque première structure de masquage comprenant une structure supérieure respective (40 ; 340), formée par la deuxième couche semi-conductrice (16), chaque deuxième structure de masquage comprenant une structure inférieure respective (75 ; 375), formée par la première couche semi-conductrice (14) ; et dans lequel, lorsque l'obturateur MEMS (1) est dans ladite au moins une condition de fonctionnement, la structure supérieure de chaque première structure de masquage chevauche partiellement les structures inférieures des deuxièmes structures de masquage adjacentes.

9. Obturateur MEMS selon la revendication 8, dans lequel chaque première structure de masquage (33 ; 333) comprend en outre une structure inférieure respective (42 ; 342), formée par la première couche semi-conductrice (14), la structure supérieure respective (40 ; 340) comprenant au moins une partie saillante (45 ; 345), qui fait saillie latéralement par rapport à ladite structure inférieure respective (42 ; 342) ; et dans lequel chaque deuxième structure de masquage (35 ; 335) comprend une structure supérieure respective (77 ; 377), qui est formée par la deuxième couche semi-conductrice (16) et laisse exposée une partie (78 ; 378) de la structure inférieure correspondante (75 ; 375) ; et dans lequel, lorsque l'obturateur MEMS (1) est dans ladite au moins une condition de fonctionnement, la partie saillante de la structure supérieure de chaque première structure de masquage recouvre au moins partiellement les parties exposées des structures inférieures des deuxièmes structures de masquage adjacentes.

10. Obturateur MEMS selon la revendication 9, dans lequel, lorsque l'obturateur MEMS (1) est dans ladite au moins une condition de fonctionnement, les parties saillantes (45 ; 345) des structures supérieures (40 ; 340) des premières structures de masquage (33 ; 333) et les parties exposées (78 ; 378) des structures inférieures (75 ; 375) des deuxièmes structures de masquage (35 ; 335) recouvrent au moins en partie l'ouverture principale (9).

11. Obturateur MEMS selon la revendication 9 ou la revendication 10, dans lequel la structure supérieure (40 ; 340) de chaque première structure de masquage (33 ; 333) comprend une portion secondaire supérieure (46 ; 346), fixe par rapport à la structure inférieure sous-jacente correspondante (42 ; 342), et une portion principale supérieure (45 ; 345), qui s'étend en porte-à-faux par rapport à la portion secondaire supérieure et forme ladite partie saillante (45 ; 345) ; et dans lequel la structure inférieure (42 ; 342) de chaque deuxième structure de masquage (35 ; 335) comprend une portion principale inférieure (78 ; 378), qui est fixe par rapport à la structure supérieure sus-jacente correspondante (77 ; 377) et forme ladite partie exposée de la structure inférieure.

12. Obturateur MEMS selon la revendication 11, dans lequel les portions principales supérieures (45 ; 345) et les portions principales inférieures (78 ; 378) sont allongées parallèlement à des directions d'extension correspondantes (R ; R'), qui sont parallèles au substrat (2).

13. Obturateur MEMS selon la revendication 12, dans lequel lesdites directions d'extension (R) sont des directions radiales.

14. Obturateur MEMS selon la revendication 12, dans lequel lesdites directions d'extension (R') sont coplanaires et équidistantes d'un axe de symétrie (H) de l'ouverture principale (9).

15. Obturateur MEMS selon n'importe laquelle des revendications 1 à 7, dans lequel les structures de masquage (433) comprennent chacune une structure supérieure respective (440), formée par la deuxième couche semi-conductrice (16), et une structure inférieure respective (442), formée par la première couche semi-conductrice (14) ; et dans lequel, lorsque l'obturateur MEMS (1) est dans ladite au moins une condition de fonctionnement, la structure supérieure de chaque structure de masquage chevauche partiellement la structure inférieure d'une structure de masquage adjacente.

16. Obturateur MEMS selon la revendication 15, dans lequel la structure supérieure (440) de chaque structure de masquage (433) comprend une partie saillante (481"), qui fait saillie latéralement par rapport à la structure inférieure correspondante (442) et laisse exposée une partie (448") de la structure inférieure correspondante (442) ; et dans lequel, lorsque l'obturateur MEMS (1) est dans ladite au moins une condition de fonctionnement, la partie saillante de la structure supérieure de chaque structure de masquage chevauche partiellement la partie exposée de la structure inférieure de la structure de masquage adjacente.

17. Obturateur MEMS selon n'importe laquelle des revendications précédentes, dans lequel les première et deuxième couches semi-conductrices (14, 16) sont constituées de polysilicium.

18. Procédé pour la fabrication d'un obturateur MEMS (1), comprenant :
- la formation d'une première couche semi-conductrice (14) sur le dessus d'un substrat (2) en matériau semi-conducteur ;
- la formation, sur le dessus de la première couche semi-conductrice (14), d'une deuxième couche semi-conductrice (16), qui forme, avec la première couche semi-conductrice (14), une structure de support (28, 71) fixée au substrat ;
- la formation d'une pluralité de structures déformables (29, 59, 69), dont chacune est formée par une portion correspondante d'au moins une des première et deuxième couches semi-conductrices ;
- la formation d'une ouverture principale (9) à travers le substrat ;
- la formation d'une pluralité d'actionneurs (36 ; 96) ; et
- la formation d'une pluralité de structures de masquage (33 ; 35 ; 333 ; 335 ; 433), dont chacune est formée par une portion correspondante d'au moins une des première et deuxième couches semi-conductrices, les structures de masquage étant agencées angulairement autour de l'ouverture principale sous-jacente de façon à assurer un masquage de l'ouverture principale, chaque structure de masquage étant en outre couplée mécaniquement à la structure de support par l'intermédiaire d'une structure déformable correspondante ;
et dans lequel chaque actionneur est commandable électriquement de façon à provoquer une rotation d'une structure de masquage correspondante entre une première position respective et une deuxième position respective, faisant ainsi varier le masquage de l'ouverture principale ; et dans lequel lesdites première et deuxième positions des structures de masquage sont telles que, dans au moins une condition de fonctionnement de l'obturateur MEMS (1), des paires de structures de masquage adjacentes se chevauchent au moins partiellement.

19. Procédé de fabrication selon la revendication 18, comprenant en outre la formation d'une pluralité de corps de couplage (100 ; 100'), dont chacun est formé par une portion correspondante d'au moins une des première et deuxième couches semi-conductrices (14, 16) et a une première extrémité (104), couplée fonctionnellement à un actionneur correspondant (36 ; 96), et une deuxième extrémité (106), fixée à une structure de masquage correspondante (33 ; 35 ; 333 ; 335 ; 433), chaque actionneur (36 ; 96) étant commandable électriquement de façon à provoquer une translation de la première extrémité du corps de couplage correspondant dans une direction parallèle à une direction de translation correspondante (R ; R') ; et dans lequel chaque structure déformable (29, 59, 69) forme une charnière correspondante (69, 71) de sorte que la translation de la première extrémité du corps de couplage correspondant provoque une rotation du corps de couplage et de la structure de masquage correspondante.

20. Procédé de fabrication selon la revendication 18 ou la revendication 19, comprenant en outre :
- la formation, sur le substrat (2), d'une région en couches (504, 506) en matériau diélectrique ;
- l'élimination sélective de portions de la région en couches (504, 506) et l'exposition d'une portion du substrat (2) ;
- la formation, sur la portion exposée du substrat (2), d'une région conductrice intermédiaire (510) ;
- la formation d'une première région diélectrique sacrificielle (515) sur la région en couches (504, 506) et sur la région conductrice intermédiaire (510) ;
- l'élimination sélective de portions de la première région diélectrique sacrificielle (515) de façon à exposer la région conductrice intermédiaire (510) ;
- la formation de la première couche semi-conductrice (14) sur la première région diélectrique sacrificielle (515) et sur la région conductrice intermédiaire (510) ;
- la formation d'une deuxième région diélectrique sacrificielle (525) sur la première couche semi-conductrice (14) de façon qu'elle recouvre, à une certaine distance, au moins une partie de la région conductrice intermédiaire (510) ;
- la formation de la deuxième couche semi-conductrice (16) sur la deuxième région diélectrique sacrificielle (525) ; et
- l'élimination sélective de portions de la deuxième couche semi-conductrice (16) de façon à former des trous supérieurs (530) qui traversent la deuxième couche semi-conductrice (16) et délimitent latéralement au moins en partie les structures de masquage (33) ;
et dans lequel la formation de l'ouverture principale (9) comprend l'élimination sélective : de portions du substrat (2) agencées en contact avec la région conductrice intermédiaire (510) ; de la région conductrice intermédiaire (510) ; de portions de la première couche semi-conductrice (14) qui recouvrent la région conductrice intermédiaire (510) et sont recouvertes par des portions correspondantes de la deuxième région diélectrique sacrificielle (525), lesdites portions correspondantes de la deuxième région diélectrique sacrificielle (525) étant recouvertes par des portions correspondantes (45) des structures de masquage (33) ; et de portions du substrat (2) qui sont décalées latéralement par rapport à la région conductrice intermédiaire (510) et sont délimitées au niveau du dessus par des portions (504) de la région en couches (504, 506) qui sont décalées latéralement par rapport à la région conductrice intermédiaire (510), qui sont recouvertes par des portions correspondantes de la première région diélectrique sacrificielle (515), lesdites portions correspondantes de la première région diélectrique sacrificielle (515) étant recouvertes par des portions correspondantes (78) des structures de masquage (35) ;
ledit procédé comprenant en outre l'élimination des première et deuxième régions diélectriques sacrificielles (515, 525) et desdites portions de la région en couches (504, 506) qui sont décalées latéralement par rapport à la région conductrice intermédiaire (510) de façon à libérer les structures de masquage.

21. Procédé de fabrication selon la revendication 20, comprenant en outre :
- la formation de motifs de la deuxième région diélectrique sacrificielle (525) de façon à exposer des portions de la première couche semi-conductrice (14) ; et
- la formation de la deuxième couche semi-conductrice (16) de façon qu'elle soit en contact avec les portions exposées de la première couche semi-conductrice (14) ; et
- l'élimination sélective de portions de la deuxième couche semi-conductrice (16) et de portions sous-jacentes de la première couche semi-conductrice (14) de façon à former des trous supplémentaires (530) qui délimitent latéralement les structures déformables (29, 69) au moins en partie.

22. Procédé de fabrication selon la revendication 20 ou la revendication 21, dans lequel la formation de la région en couches (504, 506) comprend :
- la formation, sur le substrat (2), d'une première couche diélectrique (504) ; et
- la formation, sur la première couche diélectrique (504), d'une deuxième couche diélectrique (506) résistante à un agent chimique ;
et dans lequel l'élimination sélective de portions de la région en couches (504, 506) comprend :
- l'élimination sélective de portions de la deuxième couche diélectrique (506) de façon à exposer une partie de la première couche diélectrique (504) ; et ensuite
- l'élimination de portions de la partie exposée de la première couche diélectrique (504) de façon à exposer ladite portion du substrat (2) ;
et dans lequel la formation de la première région diélectrique sacrificielle (515) comprend la formation de la première région diélectrique sacrificielle (515) sur des portions de la partie exposée de la première couche diélectrique (504) qui sont décalées latéralement par rapport à la région conductrice intermédiaire (510) ; et dans lequel lesdites portions (504) de la région en couches (504, 506) qui sont décalées latéralement par rapport à la région conductrice intermédiaire (510) comprennent lesdites portions de la partie exposée de la première couche diélectrique (504) qui sont décalées latéralement par rapport à la région conductrice intermédiaire (510) ; et dans lequel l'élimination des première et deuxième régions diélectriques sacrificielles (515, 525) et desdites portions de la région en couches (504, 506) qui sont décalées latéralement par rapport à la région conductrice intermédiaire (510) comprend la réalisation d'une gravure avec ledit agent chimique.

23. Procédé de fabrication selon n'importe laquelle des revendications 18 à 22, comprenant la formation, sur la région en couches (504, 506), de régions d'ancrage conductrices (8) qui sont décalées latéralement par rapport à la région conductrice intermédiaire (510) ; et dans lequel la formation de la première région diélectrique sacrificielle (515) comprend la formation de la première région diélectrique sacrificielle (515) sur les régions d'ancrage conductrices (8) ; ledit procédé comprenant en outre l'élimination de portions supplémentaires de la première région diélectrique sacrificielle (515) de façon à exposer les régions d'ancrage conductrices (8) ; et dans lequel la formation de la première couche semi-conductrice (14) comprend la formation de la première couche semi-conductrice (14) sur les régions d'ancrage conductrices (8).
